# EUROPÄISCHE PATENTSCHRIFT

(11) **EP 2 838 968 B1**
(45) Veröffentlichungstag und Bekanntmachung des Hinweises auf die Patenterteilung: **09.09.2020**
(21) Anmeldenummer: 13712757.7
(22) Anmeldetag: 25.03.2013
(51) Int. Cl.: C09J 153/02, C08F 8/36, H01L 51/52, C08K 5/00, C09J 191/00, C08L 53/02, C08L 91/00, C09J 193/04, C09J 153/00, C09J 11/06, C09J 7/38, C08K 5/07

(54) **VERNETZBARE KLEBMASSE MIT HART- UND WEICHBLÖCKEN ALS PERMEANTENBARRIERE**
CROSS-LINKABLE ADHESIVE COMPOUND WITH HARD AND SOFT BLOCKS AS A PERMEANT BARRIER
MATIÈRE ADHÉSIVE RÉTICULABLE PRÉSENTANT DES BLOCS DURS ET MOUS EN TANT QUE BARRIÈRE DE PERMÉATION

(30) Priorität: 17.04.2012 DE 102012206273
(43) Veröffentlichungstag der Anmeldung: 25.02.2015
(73) Patentinhaber: tesa SE, 22848 Norderstedt (DE)
(72) Erfinder: KRAWINKEL, Thorsten, 22457 Hamburg (DE); KEITE-TELGENBÜSCHER, Klaus, 22529 Hamburg (DE); GRÜNAUER, Judith, 22117 Hamburg (DE); ELLINGER, Jan, 20255 Hamburg (DE)
(86) Internationale Anmeldenummer: PCT/EP2013/056287
(87) Internationale Veröffentlichungsnummer: WO 2013/156271

(56) Entgegenhaltungen:
- EP-A1- 2 166 593
- WO-A1-2010/063579
- WO-A2-01/92344
- US-A1- 2007 021 569

## Beschreibung

Die vorliegende Erfindung betrifft eine Klebemasse, insbesondere temperaturstabile Klebemasse, umfassend (i) Blockcopolymere sowie Mischungen dieser, mit einem Aufbau A-B-A, (A-B)ₙ, (A-B)ₙX oder (A-B-A)ₙX, wobei X der Rest eines Kopplungsreagenzes ist, n eine ganze Zahl zwischen 2 und 10, A ein Polymerblock aus einem Vinylaromaten und B ein Polymerblock aus einem Alken oder Dien, wobei dieser Polymerblock auch hydriert sein kann, mit der Bedingung, dass zumindest ein Teil der A-Blöcke sulfoniert ist, optional als Zumischkomponente Zweiblockcopolymere der Form A-B und (ii) mindestens ein Klebharz und optional (iii) mindestens einen Metallkomplex mit einem substituierbaren Komplexbildner.

(Opto-)Elektronische Anordnungen werden immer häufiger in kommerziellen Produkten verwendet. Sie umfassen anorganische oder organische elektronische Strukturen, beispielsweise organische, metallorganische oder polymere Halbleiter oder auch Kombinationen dieser. Je nach gewünschter Anwendung sind sie starr oder flexibel ausgebildet, wobei eine zunehmende Nachfrage nach flexiblen Anordnungen besteht.

Als Beispiele für bereits kommerzielle oder in ihrem Marktpotential interessante (opto-)elektronische Anwendungen seien hier elektrophoretische oder elektrochrome Aufbauten oder Displays, organische oder polymere Leuchtdioden (OLEDs oder PLEDs) in Anzeige- und Display-Vorrichtungen oder als Beleuchtung genannt, Elektrolumineszenzlampen, lichtemittierende elektrochemische Zellen (LEECs), organische Solarzellen, bevorzugt Farbstoff- oder Polymersolarzellen, anorganische Solarzellen, bevorzugt Dünnschichtsolarzellen, insbesondere auf der Basis von Silizium, Germanium, Kupfer, Indium und/oder Selen, organische Feldeffekt-Transistoren, organische Schaltelemente, organische optische Verstärker, organische Laserdioden, organische oder anorganische Sensoren oder auch organisch- oder anorganisch basierte RFID-Transponder angeführt.

Als technische Herausforderung für die Realisierung einer ausreichenden Lebensdauer und Funktion von (opto-)elektronischen Anordnungen im Bereich der anorganischen und/oder organischen (Opto-)Elektronik, ganz besonders im Bereich der organischen (Opto-)Elektronik, ist ein Schutz der darin enthaltenen Komponenten vor Permeanten zu sehen. Permeanten können Atome, Ionen oder eine Vielzahl von niedermolekularen organischen oder anorganischen Verbindungen sein, insbesondere Wasserdampf und Sauerstoff.

Eine Vielzahl von (opto-)elektronischen Anordnungen im Bereich der anorganischen und/oder organischen (Opto-)Elektronik, ganz besonders bei Verwendung von organischen Rohstoffen, ist sowohl gegen Wasserdampf als auch gegen Sauerstoff empfindlich, wobei für viele Anordnungen das Eindringen von Wasserdampf als größeres Problem eingestuft wird. Während der Lebensdauer der elektronischen Anordnung ist deshalb ein Schutz durch eine Verkapselung erforderlich, da andernfalls die Leistung über den Anwendungszeitraum nachlässt. So kann sich beispielsweise durch eine Oxidation der Bestandteile etwa bei lichtemittierenden Anordnungen wie Elektrolumineszenz-Lampen (EL-Lampen) oder organischen Leuchtdioden (OLED) die Leuchtkraft, bei elektrophoretischen Displays (EP-Displays) der Kontrast oder bei Solarzellen die Effizienz innerhalb kürzester Zeit drastisch verringern.

Bei der anorganischen und/oder organischen (Opto-)Elektronik, insbesondere bei der organischen (Opto-)Elektronik, gibt es besonderen Bedarf für flexible Klebelösungen, die eine Permeationsbarriere für Permeanten, wie Sauerstoff und/oder Wasserdampf, darstellen. Die flexiblen Klebelösungen sollen daher nicht nur eine gute Haftung zwischen zwei Substraten erzielen, sondern zusätzlich Eigenschaften wie deutlich verbesserte Permeationsbarriereeigenschaften, hohe Temperaturbeständigkeit, hohe Scherfestigkeit und Schälfestigkeit, chemische Beständigkeit, Alterungsbeständigkeit, hohe Transparenz, einfache Prozessierbarkeit sowie hohe Flexibilität und Biegsamkeit erfüllen. Um ein sehr breites Anwendungsspektrum für Barriereklebemassen gewährleisten zu können, werden zunehmend auch verbesserte Barriereeigenschaften, vorzugsweise gekoppelt an eine hohe Temperaturbeständigkeit, gefordert. Diese Kombination ist dann notwendig, wenn beispielsweise (opto)elektronische Bauteile gekapselt werden, die während ihres Betriebes warm bis heiß werden, sei es durch eine Wärmeentwicklung oder aufgrund der Umgebung, in der sie eingesetzt werden. Die Verwendung von Barriereklebemasse zur Herstellung von Solarpanels oder auch von elektronischen Bauteilen, die in Offshore-Parks zum Einsatz kommen, stellen besondere Herausforderungen an die Temperaturbeständigkeit und die Barriereeigenschaften der Klebemasse.

Um eine möglichst gute Versiegelung zu erzielen, werden spezielle Barriereklebemassen verwendet. Eine gute Klebemasse für die Versiegelung von (opto-)elektronischen Bauteilen weist eine geringe Permeabilität gegen Sauerstoff und insbesondere gegen Wasserdampf auf, hat eine ausreichende Haftung auf dem Substrat und kann gut auf dieses auffließen. Ein geringes Auffließvermögen auf dem Substrat kann durch unvollständige Benetzung der Substratoberfläche und durch zurückbleibende Poren die Barrierewirkung an der Grenzfläche verringern, da ein seitlicher Eintritt von Sauerstoff und Wasserdampf unabhängig von den Eigenschaften der Klebemasse ermöglicht wird. Nur wenn der Kontakt zwischen Masse und Substrat durchgängig ist, sind die Masseeigenschaften der bestimmende Faktor für die Barrierewirkung der Klebemasse.

Zur Charakterisierung der Barrierewirkung werden üblicherweise die Sauerstofftransmissionsrate OTR (Oxygen Transmission Rate) sowie die Wasserdampftransmissionsrate WVTR (Water Vapor Transmission Rate) angegeben. Die jeweilige Rate gibt dabei den flächen- und zeitbezogenen Fluss von Sauerstoff beziehungsweise Wasserdampf durch einen Film unter spezifischen Bedingungen von Temperatur und Partialdruck sowie gegebenenfalls weiterer Messbedingungen wie relativer Luftfeuchtigkeit an. Je geringer diese Werte sind, desto besser ist das jeweilige Material zur Kapselung geeignet. Die Angabe der Permeation basiert dabei nicht allein auf den Werten für WVTR oder OTR, sondern beinhaltet immer auch eine Angabe zur mittleren Weglänge der Permeation wie zum Beispiel die Dicke des Materials oder eine Normalisierung auf eine bestimmte Weglänge.

Die Permeabilität P ist ein Maß für die Durchlässigkeit eines Körpers für Gase und/oder Flüssigkeiten. Ein niedriger P-Wert kennzeichnet eine gute Barrierewirkung. Die Permeabilität P ist ein spezifischer Wert für ein definiertes Material und einen definierten Permeanten unter stationären Bedingungen bei bestimmter Permeationsweglänge, Partialdruck und Temperatur. Die Permeabilität P ist das Produkt aus Diffusions-Term D und Löslichkeits-Term S: P = D*S

Der Löslichkeitsterm S beschreibt vorliegend die Affinität der Barriereklebemasse zu den Permeanten. Im Fall von Wasserdampf wird beispielsweise ein geringer Wert für S von hydrophoben Materialen erreicht. Der Diffusionsterm D ist ein Maß für die Beweglichkeit des Permeanten im Barrierematerial und ist direkt abhängig von Eigenschaften, wie der Molekülbeweglichkeit oder dem freien Volumen. Oft werden bei stark vernetzten oder hochkristallinen Materialen für D relativ niedrige Werte erreicht. Hochkristalline Materialien sind jedoch in der Regel weniger transparent und eine stärkere Vernetzung führt zu einer geringeren Flexibilität. Die Permeabilität P steigt üblicherweise mit einer Erhöhung der molekularen Beweglichkeit an, etwa auch wenn die Temperatur erhöht oder der Glasübergangspunkt überschritten wird.

Ein geringer Löslichkeitsterm S ist meist unzureichend, um gute Barriereeigenschaften zu erreichen. Ein klassisches Beispiel dafür sind insbesondere Siloxan-Elastomere. Die Materialien sind äußerst hydrophob (kleiner Löslichkeitsterm), weisen aber durch ihre frei drehbare Si-O-Bindung (großer Diffusions-Term) eine vergleichsweise geringe Barrierewirkung gegen Wasserdampf und Sauerstoff auf. Für eine gute Barrierewirkung ist also eine gute Balance zwischen Löslichkeitsterm S und Diffusionsterm D notwendig.

Ansätze, um die Barrierewirkung einer Klebemasse zu erhöhen, müssen die beiden Parameter D und S insbesondere im Hinblick auf den Einfluss auf die Durchlässigkeit von Wasserdampf und Sauerstoff berücksichtigen. Zusätzlich zu diesen chemischen Eigenschaften müssen auch Auswirkungen physikalischer Einflüsse auf die Permeabilität bedacht werden, insbesondere die mittlere Permeationsweglänge und Grenzflächeneigenschaften (Auffließverhalten der Klebemasse, Haftung). Die ideale Barriereklebemasse weist geringe D-Werte und S-Werte bei sehr guter Haftung auf dem Substrat auf.

Hierfür werden bisher vor allem Flüssigklebstoffe und Adhäsive auf Basis von Epoxiden verwendet (WO98/21287 A1; US 4,051,195 A; US 4,552,604 A). Diese haben durch eine starke Vernetzung einen geringen Diffusionsterm D. Ihr Haupteinsatzgebiet sind Randverklebungen starrer Anordnungen, aber auch mäßig flexibler Anordnungen. Eine Aushärtung erfolgt thermisch oder mittels UV-Strahlung. Eine vollflächige Verklebung ist aufgrund des durch die Aushärtung auftretenden Schrumpfes kaum möglich, da es beim Aushärten zu Spannungen zwischen Kleber und Substrat kommt, die wiederum zur Delaminierung führen können.

Der Einsatz dieser flüssigen Klebstoffe birgt eine Reihe von Nachteilen. So können niedermolekulare Bestandteile (VOC - volatile organic compound) die empfindlichen elektronischen Strukturen der Anordnung schädigen und den Umgang in der Produktion erschweren. Der Klebstoff muss aufwändig auf jeden einzelnen Bestandteil der Anordnung aufgebracht werden. Die Anschaffung von teuren Dispensern und Fixiereinrichtungen ist notwendig, um eine genaue Positionierung zu gewährleisten. Die Art der Auftragung verhindert zudem einen schnellen kontinuierlichen Prozess und auch durch den anschließend erforderlichen Laminationsschritt kann durch die geringe Viskosität das Erreichen einer definierten Schichtdicke und Verklebungsbreite in engen Grenzen erschwert sein.

Des Weiteren weisen solche hochvernetzten Klebstoffe nach dem Aushärten nur noch eine geringe Flexibilität auf. Der Einsatz von 2-Komponenten-Systemen wird durch die Topfzeit begrenzt, also durch die Verarbeitungszeit bis eine Vergelung stattgefunden hat.

Insbesondere wenn die (opto-)elektronischen Anordnungen flexibel sein sollen, ist es wichtig, dass der verwendete Kleber nicht zu starr und spröde ist. Daher sind besonders Haftklebemassen und hitzeaktiviert verklebbare Klebefolien geeignet für eine solche Verklebung. Um auf den Untergrund gut aufzufließen, aber gleichzeitig eine hohe Verklebungsfestigkeit zu erzielen, sollten die Klebemassen zunächst möglichst weich sein, dann aber vernetzt werden können. Als Vernetzungsmechanismen lassen sich je nach chemischer Basis der Klebemasse Temperaturhärtungen und/oder Strahlenhärtungen durchführen.

Die DE 10 2008 060 113 A1 beschreibt ein Verfahren zur Kapselung einer elektronischen Anordnung gegen Permeanten, bei dem eine Haftklebemasse auf Basis von Butylenblockcopolymeren, insbesondere Isobutylenblockcopolymeren, genutzt wird, und die Verwendung einer solchen Klebemasse in einem Kapselungsverfahren. In Kombination mit den Elastomeren werden bestimmte Harze, charakterisiert durch DACP- und MMAP-Werte, bevorzugt. Die Klebemasse ist zudem bevorzugt transparent und kann UVblockende Eigenschaften zeigen. Als Barriereeigenschaften weist die Klebemasse bevorzugt ein WVTR von < 40 g/m^{2*}d und ein OTR von < 5000 g/m^{2*}d bar auf. In dem Verfahren kann die Haftklebemasse während und/oder nach der Applikation erwärmt werden. Die Haftklebemasse kann vernetzt werden zum Beispiel strahlenchemisch. Die Haftklebemasse ist nicht temperaturstabil.

Klebemassen auf der Basis von Polyisobutylen weisen aufgrund ihrer geringen Polarität eine gute Barriere gegen Wasserdampf auf, haben aber selbst bei hohen Molekulargewichten eine relativ geringe Kohäsivität, weshalb sie bei erhöhten Temperaturen häufig eine geringe Scherfestigkeit aufweisen. Der Anteil an niedermolekularen Bestandteilen kann nicht beliebig reduziert werden, da sonst die Haftung deutlich verringert wird und die Grenzflächenpermeation zunimmt. Bei Einsatz eines hohen Anteils an funktionellen Harzen, der aufgrund der sehr geringen Kohäsion der Masse notwendig ist, wird die Polarität der Masse wieder erhöht und damit der Löslichkeits-Term vergrößert.

JP 4,475,084 B1 lehrt transparente Siegelmassen für organische Elektrolumineszenzelemente, diese können auf Blockcopolymerbasis sein. Als Beispiele sind SIS und SBS sowie die hydrierten Varianten aufgeführt. Nicht genannt sind jedoch Bestandteile, die eine Vernetzung nach Applikation erlauben. Ebenso wenig wird auf die Barriereeigenschaften der Siegelmassen eingegangen. Offenbar übernimmt die Siegelschicht keine spezielle Barriereaufgabe.

Beschrieben sind weiterhin Barriereklebemassen auf der Basis von Styrolblockcopolymeren, möglichst hydrierten und entsprechend hydrierten Harzen, DE 10 2008 047 964 A1.

Sowohl die Haftklebemassen auf Basis von Polyisobutylen als auch solche auf Basis von hydrierten Styrolblockcopolymeren zeigen einen bedeutenden Nachteil. Bei einer Verklebung zwischen zwei Folien, die mit einer Barriereschicht versehen sind, zum Beispiel zwei PET-Folien mit einer SiOx-Beschichtung, wie sie zum Beispiel für organische Solarzellen eingesetzt werden kann, kommt es bei einer Lagerung in der Feuchte und Wärme zu einer starken Blasenbildung. Auch ein vorheriges Trocknen der Folien und/oder Klebemasse kann diese Blasenbildung nicht verhindern.

Besonders problematisch ist, dass in der Regel jede Art von Funktionalisierung (über die Reaktivität geschaffen werden soll) einen Anstieg an Grundpolarität und damit eine unerwünschte Erhöhung an Wasserdampfpermeabilität der Klebemasse bedingt. Aufgabe der Erfindung ist es, eine Klebemasse zur Verfügung zu stellen, die ausgezeichnete Barriereeigenschaften gegenüber Permeanten zeigt und zudem temperaturstabil ist. Insbesondere soll die Klebemasse über einen weiten Temperaturbereich ausgezeichnete Barriereeigenschaften gegenüber Wasserdampf und Sauerstoff aufweisen. Daher ist es auch eine Aufgabe, eine Klebemasse zu entwickeln, die den schädlichen Einfluss von Sauerstoff und Wasserdampf auf empfindliche Funktionsschichten wie zum Beispiel im Bereich von anorganischen oder organischen Photozellen für Solarmodule oder im Bereich von organischen Licht emittierenden Dioden (OLEDs) durch eine gute Barrierewirkung gegenüber den schädlichen Substanzen unterbinden kann, die verschiedene Bauteile der Funktionselemente dauerhaft miteinander verbinden kann, die eine gute Performance bei hohen Temperaturen hat und die gut handhabbar in Verklebungsprozessen ist, die zudem eine flexible und saubere Verarbeitung erlaubt und die trotzdem beim Hersteller einfach zu verarbeiten ist.

Gelöst wird diese Aufgabe durch eine Klebemasse, wie sie im Hauptanspruch näher gekennzeichnet ist. In den Unteransprüchen sind vorteilhafte Ausführungsformen der Erfindung beschrieben. Ferner wird die Aufgabe gelöst durch eine Klebemasse, die gemäß dem erfindungsgemäßen Verfahren erhalten wird, sowie durch das erfindungsgemäße Verfahren zur Herstellung der Klebemasse selbst. Des Weiteren werden die Aufgaben durch die in den Ansprüchen genannte Verwendung der erfindungsgemäßen Klebemasse gelöst.

Es war aus vorgenannten Gründen überraschend, dass mit der erfindungsgemäßen, zumindest teilweise sulfonierten Klebemasse ausgezeichnete Barriereeigenschaften gegenüber Permeanten erzielt werden können und die Klebemasse zugleich eine hervorragende Temperaturbeständigkeit aufweist

Gegenstand der Erfindung sind Klebemassen sowohl Haftklebmassen als auch Schmelzklebmassen als Permeantenbarriere, insbesondere als temperaturstabile Permeantenbarriere umfassend:
(i) Blockcopolymere sowie Mischungen dieser, mit einem Aufbau A-B-A, (A-B)ₙ, (A-B)ₙX oder (A-B-A)ₙX, wobei X der Rest eines Kopplungsreagenzes ist, n eine ganze Zahl zwischen 2 und 10, A ein Polymerblock (A-Block) aus einem Vinylaromaten und B ein Polymerblock aus einem Alken oder Dien, vorzugsweise ist der Polymerblock B zumindest teilweise, bevorzugt vollständig hydriert, und wobei zumindest ein Teil der A-Blöcke sulfoniert sind, optional als Zumischkomponente Zweiblockcopolymere der Form A-B, insbesondere unabhängig ein Copolymer mit A' einem Polymerblock aus Vinylaromaten und B' einem Polymerblock aus einem Alken oder Dien, insbesondere ist n jeweils unabhängig 2, 3, 4, 5, 6, 7, 8, 9 oder 10, und
(ii) mindestens ein Klebharz und optional
   (i) mindestens einen Metallkomplex mit einem substituierbaren Komplexbildner.

Die erfindungsgemäße Klebemasse ist vorzugsweise eine vernetzbare Klebemasse, insbesondere eine koordinativ vernetzbare Klebemasse, vorzugsweise basierend auf sulfonierten Vinylaromatenblockcopolymeren mit guter Verarbeitbarkeit und Beschichtbarkeit. Weiter zeichnen sie sich durch gute Produkteigenschaften in Bezug auf Adhäsion und Kohäsion aus und zeigen hervorragende Barriereeigenschaften gegenüber Permeanten selbst bei hohen Temperaturen. Aufgrund der Vernetzung lässt sich eine hohe Temperaturbeständigkeit einstellen, wobei zugleich die Bildung von Blasen während einer Lagerung bei Wärme und Feuchtigkeit zuverlässig unterbunden werden kann.

Um die erfindungsgemäßen Barriereeigenschaften gegen Permeanten einzustellen, wird ein gewisser Grad an Sulfonierung der Blockcopolymere angestrebt, die dann als sulfonierte Copolymere bezeichnet werden. Bevorzugte Klebemassen zeichnen sich durch einen definierten Gehalt an sulfonierten Aromaten im Verhältnis zum Gesamtgehalt der genannten Aromaten aus.

Bevorzugt liegen ein Teil der A-Blöcke des Blockcopolymers, nachfolgend wird dieses Blockcopolymer auch als sulfoniertes Copolymer bezeichnet, als sulfonierte A-Blöcke vor, wobei deren Aromaten zwischen größer gleich 0,5 Mol-% je Mol der Monomereneinheit, bezogen auf die Gesamtmonomereinheiten der A-Blöcke der sulfonierten Copolymere sulfoniert sind, insbesondere zwischen größer gleich 0,5 bis 50 Mol-%, vorzugsweise größer gleich 0,5 bis 20 Mol-%. Erfindungsgemäß weist das sulfonierte Copolymer sulfonierte A-Blöcke auf, deren Vinylaromaten zwischen größer gleich 0,5 bis 15 Mol-% je Mol der Monomereinheit bezogen auf die Gesamtmonomereinheiten der A-Blöcke im sulfonierten Copolymer sulfoniert sind, insbesondere umfasst das (i) Copolymer, umfassend das sulfonierte Copolymer, A-Blöcke (Hartblock) aus polymersierten Vinylaromaten, wie Styrol, die zu 0,5 bis 13 Mol-% je Mol Gesamt-Vinylaromaten in den A-Blöcken sulfoniert sind, vorzugsweise 1 bis 10 Mol-%, bevorzugt 1 bis 8 Mol-%, besonders bevorzugt 3 bis 6 Mol-%, generell kann jeder Wert um plus/minus 2 Mol-%, vorzugsweise um plus/minus 1 Mol-% schwanken.

Die Polymere der Klebemasse der vorliegenden Erfindung sind Blockcopolymere sowie Mischungen dieser mit einem Aufbau A-B-A, (A-B)ₙ, (A-B)ₙX oder (A-B-A)ₙX, wobei X der Rest eines Kopplungsreagenzes ist, n eine ganze Zahl zwischen 2 und 10, A ein Polymerblock aus einem Vinylaromaten und B ein Polymerblock (Komponente B) aus einem Alken oder Dien, wobei dieser Polymerblock auch hydriert sein kann, mit der Bedingung, dass zumindest ein Teil der A-Blöcke sulfoniert ist, optional als Zumischkomponente Zweiblockcopolymere der Form A-B .

Übliche Kopplungsreagenzien zur Herstellung von Zwei-, Drei- sowie Multi- und Sternblockcopolymeren sind dem Fachmann bekannt. Um nur einige zu nennen, werden beispielhaft 2-Vinylpyridin, 1,4-Di(brommethyl)benzol, Dichlordimethylsilan oder 1,2-Bis(trichlorsilyl)ethan genannt, ohne die Kopplungsreagenzien darauf zu beschränken. Von diesen Kopplungsreagenzien verbleibt nach der Kopplung X als Rest.

Optional können auch unsulfonierte Blockcopolymere, insbesondere als Zumischkomponente der Form A-B, vorzugsweise unabhängig mit A'-Blöcken (Hartblock) und B'-Blöcken zum Einsatz kommen, beispielsweise als A'-B', wobei A' Polymerblöcke aus Vinylaromaten wie Styrol sind. B'-Blöcke sind vorzugsweise Polymerblöcke hydrierter linearer, verzweigter oder cyclischer Alkene und/oder Diene, mit vorzugsweise 2 bis 8 C-Atomen als Alken oder Dien.

Bereits bei geringer Sulfonierung, vorzugsweise bei größer gleich 0,5 Mol-% Sulfonierung kann überraschend eine Verbesserung der Barrierewirkung gegenüber Permeanten erzielt werden. Eine hervorragende Barrierewirkung wird bereits bei unvernetzten, getrockeneten Klebemassen umfassend das sulfonierte Polymer, beobachtet. Bei Bedarf kann zusätzlich mit einem Metallkomplex vernetzt werden, dies ist jedoch für die Barrierewirkung nicht zwingend notwendig. Gute Barriereeigenschaften werden schon bei Werten im Bereich von 1 bis 15 Mol-% erzielt, vorzugsweise 2 bis 10 Mol-%, jeweils vorzugsweise in Bezug auf die Gesamtmonomereinheiten der A-Blöcke der sulfonierten Copolymere. Weiter gesteigert werden kann die Barrierewirkung, wenn zusätzlich vernetzt wird. Durch die Vernetzung wird die Diffusion von Permeanten hervorragend unterbunden und zugleich, im Falle der zusätzlichen Vernetzung, eine gute Temperaturstabiliät der Klebemasse bewirkt, ohne dass die Klebemasse zu polar wird. Nachteil einer polaren Klebemasse wäre die Ausbildung von Wasserstoffbrückenbindungen mit Wassermolekülen, so dass diese Klebemassen keine ausreichenden Barriereeigenschaften gegenüber Wasser aufweisen. Die Sulfonierung erfolgt vorzugsweise nur am Aromaten der A-Blöcke.

Blockcopolymere mit weichen und harten Komponenten, deren T_{g} deutlich divergieren, bilden in der Regel bei Raumtemperatur eine Domänenstruktur, die für permeationshemmende Eigenschaften bei Klebemassen angestrebt wird. Die unmodifizierten Blockcopolymere von Styrol-Blöcken und Dien/Isobutylen/Butylen/Ethylen/Propylen-Blöcken sind meist nur bis 85 oder bis 100 °C schestabil, in diesem Temperaturbereich beginnen sich die Domänenstrukturen aufzulösen. Ein kritischer Punkt für thermisch stabile und zugleich Permeanten hemmende Klebemassen ist eine Erhöhung der Vernetzung, möglichst nach einer Verarbeitung, um zuvor gut auffließende Klebemassen zu haben, ohne die Polarität zu sehr zu erhöhen.

Grundsätzlich kann eine Modifizierung am Hart- und/oder am Weichblock der Blockcopolymere erfolgen. Es hat sich jedoch gezeigt, dass eine Modifikation am Weichblock sich negativ auf das Fließverhalten der Klebemasse auswirkt. Derartig modifizierte Klebemassen werden häufig zu hart und kleben auf vielen Untergründen unzureichend.

Erfindungsgemäß wurde gefunden, dass die Modifizierung, insbesondere Sulfonierung der Hart-Blöcke der Blockcopolymere, vorzugsweise der Aromaten der Alkenfunktionalisierten Aromaten wie Vinylaromaten, weiterhin ein gutes Auffließen im unvernetzten Zustand erlaubt, und hervorragende Barriereeigenschaften gegenüber Permeanten auch bei hohen Temperaturen möglich sind. Aufgrund der Sulfonierung können bereits ohne Vernetzung leicht verbesserte Schereigenschaften gegenüber den unmodifizierten Blockcopolymeren beobachtet werden. Eine anschließende Vernetzung der Sulfonsäure-Gruppen oder Sulfonsäure-Derivate wie Ester über eine koordinative Vernetzung mit einem Metall, vorzugsweise mit Aluminium eines Aluminiumchelats, führt zu einer weiteren deutlichen Verbesserung der Schereigenschaften der vernetzen Klebemassen. Je nach späterer Anwendung wird das Metall im Metallchelat ausgewählt, um eine unerwünschte Verunreinigung mit Metallen in empfindlichen Anwendungen zu vermeiden.

Bevorzugt umfassen die (i) Blockcopolymere sulfonierte Copolymere in der Klebemasse mit sulfonierten A-Blöcken und (unsulfoniert) B-Blöcken sowie unsulfonierte Copolymere, insbesondere gegebenenfalls Triblockcopolymere oder als Zumischkomponente der Form A-B, wobei die Zumischkomponente der Form A-B bevorzugt unabhängig ein Blockcopolymer mit A'-Blöcken und B'-Blöcken ist. Insbesondere umfasst die Klebemasse ein Blockcopolymer mit vernetzten sulfonierten A-Blöcken, besonders bevorzugt sind sie koordinativ über Metalle vernetzt, insbesondere gemäß Metallchelate der allgemeinen Formel I.

Durch die Auswahl der Bestandteile der Klebemasse und die geringe Polarität trotz Sulfonierung der unpolaren Vinylaromatenblockcopolymere und dem resultierenden niedrigen Löslichkeitsterm (S) des Diffusionskoeffizienten wird ein niedriges Durchtrittsvermögen von Permeanten wie Wasserdampf und Sauerstoff erreicht.

Gegenstand der Erfindung sind zudem Klebemassen, deren Blöcke unterschiedliche T_{g}s (bestimmbar über DSC) aufweisen, und durch eine Unlöslichkeit der einzelnen Phasen ineinander eine Ausbildung von Domänen ermöglichen. Durch die Bildung dieser Domänen innerhalb eines Blockcopolymers können eine sehr gute Kohäsion bei Raumtemperatur und gleichzeitig verbesserte Barriereeigenschaften erreicht werden. Daher ist es bevorzugt, wenn in den Copolymeren (i) die A-Blöcke jeweils unabhängig (A und A') einen T_{g} größer 40 °C und die B-Blöcke jeweils unabhängig (B, B') einen T_{g} kleiner 0 °C aufweisen. Vorzugsweise weisen die A-Blöcke bereits vor der Sulfonierung einen T_{g} größer 40 °C auf.

Besonders bevorzugte Klebemassen weisen einen WVTR kleiner gleich 100 g/m²·d auf. Vorzugsweise weisen chelatvernetzte Klebemassen einen WVTR kleiner gleich 100 g/m²·d auf, vorzugsweise kleiner gleich 95 g/m²·d, bevorzugt kleiner gleich 80 g/m²·d, besonders bevorzugt kleiner gleich 50 g/m²·d, ebenso besonders bevorzugt kleiner gleich 40 g/m²·d, 30 g/m²·d, 20 g/m²·d oder kleiner gleich 10 g/m²·d, und/oder die chelatvernetzte Klebemasse weist eine OTR kleiner gleich 7000 g/m²·d·bar auf, insbesondere kleiner oder gleich 3000 g/m²·d·bar, bevorzugt kleiner gleich 1000 g/m²·d·bar, besonders bevorzugt kleiner gleich 500 g/m²·d·bar.

Bevorzugte Klebemassen zeichnen sich weiter dadurch aus, dass in den Copolymeren die A-Blöcke unabhängig Homo- oder Copolymere sind, die gebildet werden aus Vinylaromaten wie Styrol oder Styrol-Derivaten und/oder α-Methylstyrol, o-, p-Methylstyrol, 2,5-Dimethylstyrol, p-Methoxystyrol und/oder tert.-Butylstyrol.

Weiter ist Gegenstand der Erfindung eine Klebemasse, die umfasst (ii) zu 10 bis 70 Gew.-% mindestens ein Klebharz, insbesondere ausgewählt aus Kohlenwasserstoffharzen, bevorzugt zumindest teilweise hydrierten Kohlenwasserstoffharzen, vorzugsweise zu 20 bis 70 Gew.-%, bevorzugt 20 bis 65 Gew.-%, besonders bevorzugt 20 bis 55 Gew.-%, ebenso besonders bevorzugt 20 bis 40 Gew.-%, insbesondere ein Kohlenwasserstoffharz aus der Gruppe der teil- oder vollständig hydrierten C₅- oder C₉-Harze vorzugsweise zu größer gleich 30 bis 55 Gew.-%, und (iii) mindestens ein Metallkomplex mit einem substituierbaren Komplexbildner, insbesondere der Formel I, und optional (iv) bis zu 20 Gew.-% einen Weichmacher, insbesondere 5 bis 15 Gew.-%, und (v) 0,0 bis 20 Gew.-%, insbesondere 0,0 bis 10,0 Gew.-%, vorzugsweise jeweils 0,0 bis 5 Gew.-% Füllstoffe, Additive, Photoinitiatoren, Beschleuniger und/oder Härter, (vi) bis zu 60 Gew.-% ein Reaktivharz als Vernetzer, insbesondere 5 bis 40 Gew.-%, und (i) die Blockcopolymere und/oder Mischungen umfassend diese ad 100 Gew.-% in der Gesamtzusammensetzung der Klebemasse, vorzugsweise liegt das Copolymer zu größer gleich 25 bis 80 Gew.-% in der Klebemasse vor, bevorzugt zu 25 bis 60 Gew.-%, besonders bevorzugt zu 30 bis 60 Gew.-%, vorzugsweise zu 30 bis 50 Gew.-%. Dabei ist es bevorzugt, wenn die A-Blöcke und die polymeren B-Blöcke jeweils als Domänen vorliegen.

Gemäß einer bevorzugten Alternative wird als Klebharz ein Kohlenwasserstoffharz zu insgesamt 20 bis 70 Gew.-%, bevorzugt 20 bis 65 Gew.-%, besonders bevorzugt 20 bis 55 Gew.-%, vorteilhaft im Gewichtsverhältnis von 2 : 1 bis 1 : 2 zum Reaktivharze als Vernetzer, vorzugsweise um etwa 1 : 1 mit einer Schwankung von plus/minus 0,5 eingesetzt.

Als Klebemassen finden bevorzugt solche auf Basis von Blockcopolymeren enthaltend A Polymerblöcke, überwiegend gebildet durch Polymerisation von Vinylaromaten, bevorzugt Styrol, und B-Blöcke, überwiegend gebildet durch Polymerisation von Alkenen oder 1,3-Dienen wie zum Beispiel Ethylen, Propylen, Butadien, Isobutylen und Isopren oder einem Copolymer aus Butadien und Isopren, Anwendung. Dabei können die Produkte auch teilweise oder vollständig im Dien-Block hydriert sein. Besonders bevorzugt sind Blockcopolymere von Polystyrol und zumindest teilhydriertem Polybutadien beziehungsweise aus Polystyrol und Polyisobutylen.

Die aus den A-Blöcken und B-Blöcken resultierenden Blockcopolymere können gleiche oder unterschiedliche B-Blöcke sowie gleiche oder unterschiedliche A-Blöcke enthalten. Einsetzbar sind ebenfalls Blockcopolymere von radialer Gestalt sowie sternförmige und lineare Multiblockcopolymere wie Triblockpolymere oder höhere Blockpolymere. Als weitere Komponenten können A-B Zweiblockcopolymere (Diblockcopolymere) vorhanden sein. Sämtliche der vorgenannten Polymere können alleine oder im Gemisch miteinander eingesetzt werden.

Anstelle der bevorzugten Polystyrolblöcke als A-Blöcke können als Vinylaromaten auch Polymerblöcke auf Basis anderer Derivate von Vinylaromaten wie aromatenhaltiger Homo- und Copolymere (bevorzugt C₈- bis C₁₂-Aromaten) mit Glasübergangstemperaturen von über 75 °C verwendet werden wie zun Beispiel α-methylstyrolhaltige Aromatenblöcke.

In einer vorteilhaften Ausführungsform weisen die Blockcopolymere einen Polyvinylaromatanteil (A-Block) von 10 Gew.-% bis 35 Gew.-% auf. Dies gilt sowohl für die sulfonierten Copolymere als auch unabhängig davon für die unsulfonierten Copolymere.

Wenigstens ein Teil der eingesetzten Blockcopolymere ist dabei im Vinylaromatenteil sulfoniert, insbesondere mit Sulfonsäure oder einem Sulfonsäurederivat, vorzugsweise einem Ester. Die Sulfonierung der Aromaten kann dabei auf verschiedenen Wegen realisiert werden. Möglich ist beispielweise eine direkte Sulfonierung mit konzentrierter Schwefelsäure oder eine Chlorsulfonierung mit Sulfurylchlorid und anschließender Verseifung der Chlorsulfonsäure. Sehr einfach und elegant ist die Umsetzung mit in situ hergestelltem Acetyl- oder Isopropylsulfat.

In einer weiteren bevorzugten Ausgestaltung beträgt der Anteil der A-Blöcke in den Blockcopolymeren mindestens 20 Gew.-% in Bezug auf Gesamtmasse der Blockcopolymere. In einer alternativen bevorzugten Ausführungsform beträgt der Anteil der Copolymere, vorzugsweise der Blockcopolymere, wie der Vinylaromatblockcopolymere in Summe bezogen auf die gesamte (Haft)klebemasse mindestens 20 Gew.-%, vorzugsweise mindestens 30 Gew.-%, weiter bevorzugt mindestens 35 Gew.-%. Ein zu geringer Anteil an Vinylaromatenblockcopolymeren hat zur Folge, dass die Kohäsion der Klebemasse relativ niedrig ist. Der maximale Anteil der Vinylaromatblockcopolymere in Summe bezogen auf die gesamte Klebemasse beträgt maximal 80 Gew.-%, bevorzugt maximal 65 Gew.-%, ganz besonders bevorzugt maximal 60 Gew.-%. Ein zu hoher Anteil an Vinylaromatenblockcopolymeren hat wiederum zur Folge, dass die Klebemasse eine zu geringe Haftung aufweist.

Das oder die Copolymere sind gemäß einer bevorzugten Ausführungsform der Erfindung Blockcopolymere mit einer Molmasse M_{w} (Gewichtsmittel) von 300.000 g/mol oder kleiner, bevorzugt 200.000 g/mol oder kleiner, besonders bevorzugt kleiner 130.000 g/mol. Kleinere Molgewichte sind dabei aufgrund ihrer besseren Verarbeitbarkeit bevorzugt.

Bei einer vorteilhaften Variante handelt es sich bei dem Blockcopolymer um ein Triblockcopolymer, das aus zwei endständigen Hartblöcken und einem mittelständigen Weichblock aufgebaut ist. Mischungen aus Triblock- und Diblockcopolymeren sind ebenfalls gut geeignet. Sehr bevorzugt werden Blockcopolymere vom Typ Polystyrolblock-Polyisobutylen-block-Polystyrol eingesetzt. Solche Systeme sind unter den Bezeichnungen SIBStar von der Firma Kaneka und Oppanol IBS von der Firma BASF bekannt gemacht worden. Weitere vorteilhaft einsetzbare Systeme sind in EP 1 743 928 A1 beschrieben. Kommerziell sind hydrierte Vinylaromatenblockcopolymere zum Beispiel unter dem Namen Kraton der Firma Kraton als Styrol-Ethylen/Butylen-Styrol-Blockcopolymere oder unter dem Namen Septon der Firma Kuraray als Styrol-Ethylen/Propylen-Styrol-Blockcopolymere bekannt.

Dadurch, dass die B-Blöcke im Copolymer einen Anteil an Isobutylen oder Butylen als zumindest eine Comonomersorte enthalten, resultiert eine unpolare Klebemasse, die vorteilhaft niedrige Volumenbarriereeigenschaften insbesondere gegenüber Wasserdampf bieten.

Bei der Klebmasse kann es sich sowohl um eine Haftklebmasse handeln, die schon bei Raumtemperatur eine gewisse Anfassklebrigkeit besitzt und nur durch Druck verklebt werden kann, als auch eine Schmelzklebmasse, die bei Raumtemperatur keine oder nur eine sehr geringe Anfassklebrigkeit besitzt und zum Verkleben erwärmt werden muss.

Aufgrund der Chelatvernetzung der Hartblöcke weisen die erfindungsgemäßen Klebemassen sehr gute Shear Adhesion Failure Temperature Werte (SAFT) auf. So können für die erfindungsgemäßen Klebemassen SAFT-Werte von größer gleich 150 °C erreicht werden, insbesondere größer gleich 180 °C, bevorzugt größer gleich 200 °C, besonders bevorzugt größer gleich 210 °C, in Abhänggkeit von der Vernetzung und dem Anteil an Hartblöcken.

Bevorzugte B-Blöcke zur Herstellung einer erfindungsgemäßen Klebemasse sind ausgewählt aus polymeren B-Blöcken, die unabhängig Homo- oder Copolymere aus monomeren Alkenen mit 2 bis 8 C-Atomen sind, vorzugsweise sind die Monomere ausgewählt aus Ethylen, Propylen, 1,3-Dienen, besonders vorzugsweise aus Butadien, Isobuten und/oder Isopren. Dabei ist es für den erfindungsgemäßen Erfolg besonders bevorzugt, wenn die B-Blöcke zumindest teilweise hydriert, insbesondere im Wesentlichen vollständig hydriert sind. Eine vorzugsweise vollständige Hydrierung der B-Blöcke verhindert eine Sulfonierung der B-Blöcke, so dass eine Klebemasse mit guter Transparenz hergestellt werden kann. Als unpolare Comonomere der B-Blöcke sind beispielsweise (teil-)hydriertes Polybutadien, (teil-)hydriertes Polyisopren und/oder Polyolefine geeignet.

Als mindestens ein Metallkomplex mit substituierbarem Komplexbildner wird vorzugsweise als Metallkomplex ein Metallchelat der Formel I verwendet,

(R¹O)ₙM(XR²Y)ₘ (I)

- wobei M ein Metall ist, ausgewählt aus Metallen der 2. 3. 4. und 5. Hauptgruppe des Periodensystems und den Übergangsmetallen, insbesondere ist M ausgewählt aus Aluminium, Zinn, Titan, Zirkonium, Hafnium, Vanadium, Niob, Chrom, Mangan, Eisen, Kobalt, und Cer, wobei M besonders bevorzugt Aluminium oder Titan ist, und
- R¹ eine Alkyl- oder Aryl-Gruppe ist, insbesondere mit 1 bis 12 C-Atomen, wie Methyl, Ethyl, Butyl, Isopropyl oder Benzyl;
- n gleich 0 oder eine größere ganze Zahl ist, insbesondere 0, 1, 2, 3 oder 4, bevorzugt ist n 0 oder 1,
- X und Y im Chelat-Ligand (XR²Y) unabhängig Sauerstoff oder Stickstoff sind, die optional mit einer Doppelbindung an R² gebunden sind, bevorzugte Chelatliganden sind Dione, wie 2,4-Pentandion,
- R² eine X und Y verbindende Alkylen-Gruppe ist, insbesondere eine bifunktionelle Alkylen-Gruppe, die linear oder verzweigt ist und optional mit Heteroatom(en) in der Alkylen-Gruppe, insbesondere Sauerstoff, Stickstoff oder Schwefel;
- m eine ganze Zahl ist, mindestens jedoch 1, insbesondere eine Zahl ausgewählt aus 1, 2 oder 3. In bevorzugten Metallchelaten ist M ausgewählt aus Aluminium, Titan und Zirkon, wobei n gleich 0, 1, 2 oder 3 ist und m gleich 1, 2, 3 oder 4.

Bevorzugte Chelatliganden sind solche, die aus der Reaktion folgender Verbindungen entstanden sind: Triethanolamin, 2,4-Pentandion, 2-Ethyl-1,3-Hexandiol oder Milchsäure. Besonders bevorzugte Vernetzer sind Aluminium- und Titanylacetylacetonate. Wie Tris(acetylacetonato)-aluminium, Bis(acetylacetonato)-titan(IV)-oxid, Bis(pentan-2,4-dionato)-titan(IV)-oxid.

Dabei sollte ein annähernd äquivalentes Verhältnis zwischen den Sulfonsäure-/ Sulfonsäurederivat-Gruppen und den Acetylacetonat-Gruppen gewählt werden, um eine optimale Vernetzung zu erreichen, wobei sich ein kleiner Überschuss an Vernetzer als positiv herausgestellt hat. Das Verhältnis zwischen Sulfonsäure- oder Sulfonsäurederivat-Gruppen und Acetylacetonat-Gruppen kann aber variiert werden, dabei sollte für eine ausreichende Vernetzung keine der beiden Gruppen in mehr als einem fünffachen molaren Überschuss vorliegen. Gegenstand der Erfindung ist vorzugsweise eine Klebemasse in der das molare Verhältnis der Sulfonsäuregruppen im (i) sulfonierten Copolymer zum Liganden (XR²Y), insbesondere zu einem Acetylacetonat-Liganden; im (iii) Metallkomplex der Formel I im Bereich von 1 : 5 bis 5 : 1 einschließlich der Grenzwerte liegt, insbesondere im Bereich von 1 : 3 bis 3 : 1, insbesondere 1 : 2 bis 2 : 1, vorzugsweise um 1 : 1 mit einer Schwankungsbreite von plus/minus 0,5, insbesondere 0,2.

In weiter bevorzugter Ausgestaltung weist die Haftklebemasse neben dem mindestens einen Vinylaromatenblockcopolymer mindestens ein Klebharz auf, um die Adhäsion in gewünschter Weise zu erhöhen. Das Klebharz sollte mit dem Elastomerblock der Blockcopolymere verträglich sein.

Als Klebharze (Klebrigmacher) können in der Haftklebemasse zum Beispiel partiell oder vollständig hydrierte Harze auf Basis von Kolophonium und Kolophoniumderivaten, hydrierte Polymerisate des Dicyclopentadiens, partiell, selektiv oder vollständig hydrierte Kohlenwasserstoffharze auf Basis von C₅-, C₅/C₉- oder C₉-Monomerströmen, hydrierte Polymerisate von bevorzugt reinen C₈- und C₉-Aromaten eingesetzt werden. Vorgenannte Klebharze können sowohl allein als auch im Gemisch eingesetzt werden. Dabei können sowohl bei Raumtemperatur feste als auch flüssige Harze zum Einsatz kommen. Um eine hohe Alterungs- und UV-Stabilität zu gewährleisten sind hydrierte Harze mit einem Hydrierungsgrad von mindestens 90 %, vorzugsweise von mindestens 95 %, bevorzugt.

Es ist vorteilhaft, wenn dieses Klebharz eine Klebharzerweichungstemperatur von größer 25 °C aufweist, insbesondere größer gleich 60 °C weiter bevorzugt größer gleich 75 °C. Es ist darüber hinaus vorteilhaft, wenn ergänzend zumindest eine Sorte Klebharz mit einer Klebharzerweichungstemperatur von kleiner 20 °C eingesetzt wird. Hierüber kann, falls erforderlich, zum einen das klebtechnische Verhalten, zum anderen aber auch das Auffließverhalten auf dem Verklebungsuntergrund feineingestellt werden.

Des Weiteren sind unpolare Harze mit einem DACP-Wert (diacetone alcohol cloud point) oberhalb von 30 °C und einem MMAP-Wert (mixed methylcylohexane aniline point) von größer 50 °C, insbesondere mit einem DACP-Wert oberhalb von 37 °C und einem MMAP-Wert größer 60 °C bevorzugt. Der DACP-Wert undder MMAP-Wert geben jeweils die Löslichkeit in einem bestimmten Lösemittel an. Durch die Auswahl dieser Bereiche wird eine besonders hohe Permeationsbarriere, insbesondere gegen Wasserdampf, erreicht.

Erfindungsgemäße Klebemassen können neben den schon erwähnten Komponenten zusätzlich auch noch Reaktivharze als Vernetzer enthalten, dieses können zum Beispiel Epoxidharze oder niedermolekulare Acrlyat- oder Methacrylatverbindungen sein, die entweder thermisch oder photochemisch vernetzt werden können. Für eine photochemische Vernetzung ist mindestens ein Photoinitiator vorhanden, der UV-Licht unterhalb 380nm absorbiert.

Als Epoxidharze werden üblicherweise sowohl monomere als auch oligomere Verbindungen mit mehr als einer Epoxidgruppe pro Molekül verstanden. Dieses können Reaktionsprodukte von Glycidestern oder Epichlorhydrin mit Bisphenol A oder Bisphenol F oder Mischungen aus diesen beiden sein. Einsetzbar sind ebenfalls Epoxidnovolakharze gewonnen durch Reaktion von Epichlorhydrin mit dem Reaktionsprodukt aus Phenolen und Formaldehyd. Auch monomere Verbindungen mit mehreren Epoxidendgruppen, die als Verdünner für Epoxidharze eingesetzt werden sind verwendbar. Ebenfalls sind elastisch modifizierte Epoxidharze einsetzbar oder epoxidmodifizierte Elastomere wie zum Beispiel epoxidierte Styrolblockcopolymere, zum Beispiel Epofriend der Firma Daicel.

Beispiele von Epoxidharzen sind AralditeTM 6010, CY-281TM, ECNTM 1273, ECNTM 1280, MY 720, RD-2 von Ciba Geigy, DERTM 331, 732, 736, DENTM 432 von Dow Chemicals, EponTM 812, 825, 826, 828, 830 etc. von Shell Chemicals, HPTTM 1071, 1079 ebenfalls von Shell Chemicals, BakeliteTM EPR 161, 166, 172, 191, 194 etc. der Bakelite AG.

Kommerzielle aliphatische Epoxidharze sind zum Beispiel Vinylcyclohexandioxide wie ERL-4206, 4221, 4201, 4289 oder 0400 von Union Carbide Corp.

Elastifizierte Epoxidharze sind erhältlich von der Firma Noveon unter dem Namen Hycar.

Epoxidverdünner, monomere Verbindungen mit mehreren Epoxidgruppen, sind zum Beispiel BakeliteTM EPD KR, EPD Z8, EPD HD, EPD WF, etc. der Bakelite AG oder PolypoxTM R 9, R12, R 15, R 19, R 20 etc. der Firma UCCP.

Epoxidharze können dabei sowohl mittels Hitze als auch mittels UV-Licht vernetzt werden. Bei der Vernetzung mit Hilfe von Hitze werden üblicherweise Härter und Beschleuniger eingesetzt. Härter können dabei auf Basis von Aminen oder Anhydriden aufgebaut sein. Beschleuniger können zum Beispiel aus der Gruppe der tertiären Amine oder modifizierten Phosphine wie zum Beispiel Triphenylphosphin kommen.

Vor einer möglichen UV-Vernetzung werden die Klebemassen in der Regel appliziert und unvernetzt oder teilvernetzt in Bezug auf die sulfonierten Copolymere beispielsweise als Transferband oder Klebeband an den Kunden geliefert, bei dem dann anschließend UV-Vernetzung erfolgt. Die so vernetzten Klebemassen können auch aufgrund ihrer Vernetzungscharakteristik als Dualcore vernetzt bezeichnet werden.

Die Epoxidharze können aromatischer oder insbesondere aliphatischer oder cycloaliphatischer Natur sein. Einsetzbare Epoxidharze können monofunktionell, difunktionell, trifunktionell, tetrafunktionell oder höher funktionell bis zu polyfunktionell gestaltet sein, wobei sich die Funktionalität auf die cyclische Ethergruppe bezieht.

Beispiele, ohne sich einschränken zu wollen, sind 3,4-Epoxycyclohexylmethyl-3',4'-epoxycyclohexancarboxylat (EEC) und Derivate, Dicyclopendadiendioxid und Derivate, 3-Ethyl-3-oxetanmethanol und Derivate, Tetrahydrophthalsäurediglycidylester und Derivate, Hexahydrophthalsäurediglycidylester und Derivate, 1,2-Ethandiglycidylether und Derivate, 1,3-Propandiglycidylether und Derivate, 1,4-Butandioldiglycidylether und Derivate, höhere 1,n-Alkandiglycidylether und Derivate, Bis-[(3,4-epoxycyclohexyl) methyl]-adipat und Derivate, Vinylcyclohexyldioxid und Derivate, 1,4-Cyclohexandimethanol-bis-(3,4-epoxycyclohexancarboxylat) und Derivate, 4,5-Epoxytetrahydrophthalsäurediglycidylester und Derivate, Bis-[1-ethyl(3-oxetanyl)methyl)ether und Derivate, Pentaerythritoltetraglycidylether und Derivate, Bisphenol-A-Digylcidylether (DGEBA), hydriertes Bisphenol-A-Diglycidylether, Bisphenol-F-Diglycidyl-ether, hydriertes Bisphenol-F-Diglycidylether, Epoxyphenol-Novolaks, hydrierte Epoxyphenol-Novolaks, Epoxycresol-Novolaks, hydrierte Epoxycresol-Novolaks.

Für eine UV-Vernetzung enthält die Klebemasseformulierung optional zudem zumindest eine Sorte eines Photoinitiators für die kationische Härtung der Reaktivharze. Unter den Initiatoren für eine kationische UV-Härtung sind insbesondere Sulfonium-, Iodonium- und Metallocen-basierende Systeme einsetzbar.

Als Beispiele für Sulfonium-basierende Kationen sei auf die Ausführungen in US 6,908,722 B1 (insbesondere Spalten 10 bis 21) verwiesen. Als Beispiele für Anionen, die als Gegenionen für die oben genannten Kationen dienen, seien Tetrafluoroborat, Tetraphenylborat, Hexafluorophosphat, Perchlorat, Tetrachloroferrat, Hexafluoroarsenat, Hexafluoroantimonat, Pentafluorohydroxyantimonat, Hexachloroantimonat, Tetrakispentafluorophenylborat, Tetrakis-(pentafluoromethylphenyl)-borat, Bi-(trifluoromethylsulfonyl)-amide und Tris-(trifluoromethylsulfonyl)-methide genannt. Ferner sind insbesondere für lodonium-basierende Initiatoren auch Chlorid, Bromid oder lodid als Anionen denkbar, wobei aber Initiatoren, die im Wesentlichen frei von Chlor und Brom sind, bevorzugt sind.

Konkreter zählen zu den einsetzbaren Systemen: Sulfonium-Salze (siehe zum Beispiel US 4,231,951 A, US 4,256,828 A, US 4,058,401 A, US 4,138,255 A und US 2010/063221 A1) wie Triphenylsulfoniumhexafluoroarsenat. Beispiele für kommerzialisierte Photoinitiatoren sind Cyracure UVI-6990, Cyracure UVI-6992, Cyracure UVI-6974 und Cyracure UVI-6976 der Firma Union Carbide, sowie weitere geeignete Photoinitiatoren. Dem Fachmann sind weitere Systeme bekannt, die ebenfalls erfindungsgemäß einsetzbar sind. Photoinitiatoren werden unkombiniert oder als Kombination von zwei oder mehreren Photoinitiatoren eingesetzt.

Vorteilhaft sind Photoinitiatoren, die Absorption bei kleiner 350 nm und vorteilhaft bei größer 250 nm aufweisen. Initiatoren, die oberhalb 350 nm absorbieren, beispielsweise im Bereich violetten Lichts, sind ebenfalls einsetzbar. Sulfonium-basierende Photoinitiatoren werden besonders bevorzugt eingesetzt, da sie eine vorteilhafte UV-Absorptionscharakteristik aufweisen.

Bevorzugt wird die Haftklebemasse erst nach der Applikation teil- oder endvernetzt, beispielsweise nach der Applikation auf einer elektronischen Anordnung.

Wie vorstehend ausgeführt, kann die erfindungsgemäße Klebemasse weiterhin zumindest eine Sorte eines Reaktivharzes auf Basis eines Acrylats oder Methacrylats für die strahlenchemische und gegebenenfalls thermische Vernetzung enthalten. Bei den Reaktivharzen auf Basis von Acrylaten oder Methacrylaten handelt es sich insbesondere um aromatische oder insbesondere aliphatische oder cycloaliphatische Acrylate oder Methacrylate, insbesondere als Monomere, als Polymere oder Mischungen dieser.

Geeignete Reaktivharze tragen zumindest eine (Meth)acrylat-Funktion, bevorzugt zumindest zwei (Meth)acrylat-Funktionen. Weitere Verbindungen mit zumindest einer (Meth)acrylat-Funktion bevorzugt höherer (Meth)acrylat-Funktionalität einzusetzen, ist im Sinne dieser Erfindung möglich.

Beim Einsatz von niedermolekularen Acrylaten als Vernetzer werden Photoinitiatoren zugesetzt, die beim Bestrahlen mit Licht Radikale bilden, die dann die Acrylate zur Vernetzung bringen. Die Klebmasseformulierung enthält zudem zumindest eine Sorte eines Photoinitiators für die radikalische Härtung dieser Reaktivharze. Vorteilhaft sind Photoinitiatoren, die Absorption bei kleiner 350 nm und vorteilhaft bei größer 250 nm aufweisen. Initiatoren, die oberhalb 350 nm absorbieren, beispielsweise im Bereich violetten Lichts, sind ebenfalls einsetzbar. Geeignete Vertreter für Photoinitiatoren für die radikalische Härtung sind Typ-I-Photoinitiatoren, also sogenannte α-Spalter wie Benzoin-und Acetophenon-Derivate, Benzilketale oder Acylphosphinoxide, Typ-II-Photoinitiatoren, also sogenannte Wasserstoffabstraktoren wie Benzophenon-Derivate und einige Chinone, Diketone und Thioxanthone. Ferner können Triazin-Derivate zur Initiierung radikalischer Reaktionen verwendet werden.

Der Klebemasse können übliche Zuschlagstoffe wie Alterungsschutzmittel (Antiozonantien, Antioxidantien, Lichtschutzmittel usw.) zugesetzt sein.

Als weitere Additive können typischerweise genutzt werden:
- Plastifizierungsmittel wie zum Beispiel Weichmacheröle oder niedermolekulare flüssige Polymere wie zum Beispiel niedermolekulare Polybutene
- primäre Antioxidantien wie zum Beispiel sterisch gehinderte Phenole
- sekundäre Antioxidantien wie zum Beispiel Phosphite oder Thioether
- Prozessstabilisatoren wie zum Beispiel C-Radikalfänger
- Lichtschutzmittel wie zum Beispiel UV-Absorber oder sterisch gehinderte Amine
- Verarbeitungshilfsmittel
- Endblockverstärkerharze sowie
- gegebenenfalls weitere Polymere von bevorzugt elastomerer Natur; entsprechend nutzbare Elastomere beinhalten unter anderem solche auf Basis reiner Kohlenwasserstoffe, zum Beispiel ungesättigte Polydiene wie natürliches oder synthetisch erzeugtes Polyisopren oder Polybutadien, chemisch im wesentlichen gesättigte Elastomere wie zum Beispiel gesättigte Ethylen-Propylen-Copolymere, α-Olefincopolymere, Polyisobutylen, Butylkautschuk, Ethylen-Propylenkautschuk, sowie chemisch funktionalisierte Kohlenwasserstoffe wie zum Beispiel halogenhaltige, acrylathaltige, allyl- oder vinyletherhaltige Polyolefine.

In einer Ausführungsform der vorliegenden Erfindung enthält die Haftklebemasse auch Füllstoffe, beispielhaft, aber nicht einschränkend erwähnt seien Metalloxide, Metallhydroxide, Carbonate, Nitride, Halogenide, Carbide oder gemischte Oxid-/Hydroxid-/ Halogenid-verbindungen der Metalle, ausgewählt aus Aluminium, Silicium, Zirkonium, Titan, Zinn, Zink, Eisen oder der (Erd)alkalimetalle. Hierbei handelt es sich im Wesentlichen um Tonerden zum Beispiel Aluminiumoxide, Boehmit, Bayerit, Gibbsit, Diaspor und ähnliche. Ganz besonders geeignet sind Schichtsilicate wie beispielsweise Bentonit, Montmorillonit, Hydrotalcit, Hectorit, Kaolinit, Boehmit, Glimmer, Vermiculit oder deren Mischungen. Aber auch Ruße oder weitere Modifikationen des Kohlenstoffs, etwa Kohlenstoffnanoröhrchen können verwendet werden.

Bevorzugt werden als Füllstoffe der Haftklebemasse nanoskalige und/oder transparente Füllstoffe verwendet, die als modifizierte Füllstoffe mit unpolaren Oberflächen oder vernetzbaren Oberflächenmolekülen eingesetzt werden. Als nanoskalig wird ein Füllstoff vorliegend bezeichnet, wenn er in mindestens einer Dimension eine maximale Ausdehnung von etwa 100 nm, bevorzugt von etwa 10 nm bis insbesondere 0,001 nm, aufweist. Besonders bevorzugt werden solche in der Masse transparente Füllstoffe mit plättchenförmiger Kristallitstruktur und einem hohen Aspektverhältnis bei homogener Verteilung verwendet. Die Füllstoffe mit plättchenartiger Kristallitstruktur und Aspektverhältnissen weit über 100 haben in der Regel nur eine Dicke von einigen nm, die Länge beziehungsweise die Breite der Kristallite kann aber bis zu einigen µm betragen. Derartige Füllstoffe werden ebenfalls als Nanopartikel bezeichnet. Die partikuläre Ausgestaltung der Füllstoffe mit kleinen Abmessungen ist zudem besonders vorteilhaft für eine transparente Auslegung der Haftklebemasse.

Durch den Aufbau labyrinthartiger Strukturen mithilfe der zuvor beschriebenen Füllstoffe in der Klebstoffmatrix wird der Diffusionsweg von zum Beispiel Sauerstoff und Wasserdampf derartig verlängert, dass ihre Permeation durch die Klebstoffschicht hindurch vermindert wird. Zur besseren Dispergierbarkeit dieser Füllstoffe in der Bindemittelmatrix können diese Füllstoffe mit organischen Verbindungen oberflächlich modifiziert: werden. Der Einsatz derartiger Füllstoffe an sich ist beispielsweise aus der US 2007/0135552 A1 sowie der WO 02/026908 A1 bekannt.

In einer weiteren vorteilhaften Ausführung der vorliegenden Erfindung werden auch Füllstoffe, die mit Sauerstoff und/oder Wasserdampf in besonderer Weise wechselwirken können, eingesetzt. In die (opto-)elektronische Anordnung eindringender Sauerstoff oder Wasserdampf wird dann an diesen Füllstoffen chemisch oder physikalisch gebunden. Diese Füllstoffe werden auch als "getter", "scavenger", "desiccants" oder "absorber" bezeichnet. Beispiele sind Cobaltchlorid, Calciumchlorid, Calciumbromid, Lithiumchlorid, Zinkchlorid, Zinkbromid, Siliciumdioxid (Silica Gel), Aluminiumoxid (aktiviertes Aluminium), Calciumsulfat, Kupfersulfat, Natriumdithionit, Natriumcarbonat, Magnesiumcarbonat, Titandioxid, Bentonit, Montmorillonit, Diatomenerde, Zeolithe und Oxide von (Erd)Alkalimetallen, wie Bariumoxid, Calciumoxid, Eisenoxid und Magesiumoxid oder auch Kohlenstoffnanoröhrchen. Des Weiteren können auch organische Absorber wie beispielsweise Polyolefin-Copolymere, Polyamid-Copolymere, PET-Copolyester oder weitere auf Hybridpolymeren basierte Absorber, die meist in Kombination mit Katalysatoren wie beispielsweise Cobalt verwendet werden eingesetzt werden. Weitere organische Absorber sind etwa schwach vernetzte Polyacrylsäure, Ascorbate, Glucose, Gallussäure oder ungesättigte Fette und Öle.

Um eine möglichst gute Wirksamkeit der Füllstoffe hinsichtlich der Barrierewirkung zu erzielen, sollte ihr Anteil nicht zu gering sein. Der Anteil beträgt vorzugsweise mindestens 5 Gew.-%, weiter bevorzugt mindestens 10 Gew.-% und ganz bevorzugt mindestens 15 Gew.-%. Typischerweise wird ein möglichst hoher Anteil von Füllstoffen eingesetzt, ohne dabei die Klebkräfte der Klebemasse zu stark herabzusetzen oder weitere Eigenschaften zu beeinträchtigen. Des Weiteren ist eine möglichst feine Verteilung und möglichst hohe Oberfläche der Füllstoffe vorteilhaft. Dies ermöglicht einen höheren Wirkungsgrad und eine höhere Beladungskapazität und wird insbesondere mit nanoskaligen Füllstoffen erreicht.
Gemäß einer bevorzugten Ausführungsform der Erfindung überschreitet der Anteil an Füllstoffen nicht einen Wert von 30 Gew.-%, um den Einfluss auf die Klebeeigenschaften möglichst gering zu halten.

Die Füllstoffe sind nicht zwingend, die Klebemasse funktioniert auch, ohne dass diese einzeln oder in beliebiger Kombination zugesetzt sind.

Im Bereich der Klebstoffe zeichnen sich Haftklebemassen insbesondere durch ihre permanente Klebrigkeit und Flexibilität aus. Ein Material, das permanente Haftklebrigkeit aufweist, muss zu jedem Zeitpunkt eine geeignete Kombination aus adhäsiven und kohäsiven Eigenschaften aufweisen. Für gute Haftungseigenschaften gilt es, Haftklebemassen so einzustellen, dass eine optimale Balance aus adhäsiven und kohäsiven Eigenschaften besteht.

Vorzugsweise ist die Klebemasse eine Haftklebemasse, also eine viskoelastische Masse, die bei Raumtemperatur in trockenem Zustand permanent klebrig und klebfähig bleibt. Die Klebung erfolgt durch leichten Anpressdruck sofort auf fast allen Substraten.

Gegenstand der Erfindung ist auch eine Klebemasse, die ausgehärtet oder vernetzt im Blasentest Werte kleiner gleich 50/cm², vorzugsweise kleiner gleich 40/cm², bevorzugt kleiner gleich 200/cm², besonders bevorzugt kleiner gleich 10/cm² liefert.

Bevorzugt wird die Klebemasse erst nach der Applikation auf dem zu verklebenden Substrat teil- oder endvernetzt.

Weiter bevorzugt kommt eine Klebemasse zum Einsatz, die in bestimmten Ausführungen im sichtbaren Licht des Spektrums (Wellenlängenbereich von etwa 400 nm bis 800 nm) transparent ist. Die gewünschte Transparenz lässt sich insbesondere durch die Verwendung farbloser Klebharze und durch Einstellung der Kompatibilität von Copolymer (in mikrophasenseparierten Systemen wie Block- und Pfropfcopolymeren mit deren Weichblock) und Klebharz aber auch mit dem Reaktivharz erzielen. Reaktivharze werden für diesen Zweck vorteilhaft aus aliphatischen und cycloaliphatischen Systemen ausgewählt. "Transparenz" bedeutet dabei eine mittlere Transmission der Klebemasse im sichtbaren Bereich des Lichts von mindestens 75 %, bevorzugt höher als 90 %, wobei sich diese Betrachtung auf unkorrigierte Transmission, also ohne Grenzflächenreflexionsverluste herauszurechnen, bezieht. Vorzugsweise zeigt die Klebemasse einen Haze kleiner 5,0 %, bevorzugt kleiner 2,5 %.

Die Herstellung und Verarbeitung der Haftklebemasse kann aus Lösung, Dispersion sowie aus der Schmelze erfolgen. Bevorzugt erfolgt die Herstellung und Verarbeitung aus Lösung oder aus der Schmelze. Besonders bevorzugt ist die Fertigung der Klebemasse aus Lösung. Dabei werden die Bestandteile der Haftklebemasse in einem geeigneten Lösungsmittel, zum Beispiel Toluol oder Mischungen aus Benzin und Aceton, gelöst und mit allgemein bekannten Verfahren auf den Träger aufgebracht. Bei der Verarbeitung aus der Schmelze können dies Auftragsverfahren über eine Düse oder einen Kalander sein. Bei Verfahren aus der Lösung sind Beschichtungen mit Rakeln, Messern, Walzen oder Düsen bekannt, um nur einige zu nennen.

Ebenfalls Gegenstand der Erfindung sind flächige Haftmittel umfassend die erfindungsgemäße Klebemasse, wobei das flächige Haftmittel ausgewählt ist aus einem Flächenelement der Klebemasse, insbesondere als Transferklebeband, vorzugsweise in Form eines Flächenelements der Klebemasse mit einer zumindest das Flächenelement teilweise bedeckenden Schicht, und wobei die Klebemasse im Wesentlichen getrocknet ist. Ferner kann das flächige Haftmittel, insbesondere ein Flächenelement der Klebemasse ein Klebeband sein, wobei das Klebeband einen Träger, insbesondere einen flächigen Träger, aufweist und mindestens auf einer Seite des Trägers die aufgebrachte Klebemasse aufweist, und die Klebemasse im Wesentlichen getrocknet ist. Das genannte Klebeband kann ein- oder doppelseitig klebendes Klebeband sein. Üblicherweise weisen Transferklebebänder zur einfacheren Herstellung, Lagerung und Verarbeitung ein Trennpapier auf. Besonders vorteilhaft lässt sich die erfindungsgemäße Klebemasse in einem ein- oder doppelseitig klebenden Klebeband verwenden. Diese Darreichungsart erlaubt eine besonders einfache und gleichmäßige Applikation der Klebemasse.

Der allgemeine Ausdruck "Klebeband" umfasst dabei ein Trägermaterial, welches ein- oder beidseitig mit einer (Haft)klebemasse versehen ist. Das Trägermaterial umfasst alle flächigen Gebilde, beispielsweise in zwei Dimensionen ausgedehnte Folien oder Folienabschnitte, Bänder mit ausgedehnter Länge und begrenzter Breite, Bandabschnitte, Stanzlinge (beispielsweise in Form von Umrandungen oder Begrenzungen einer (opto-)elektronischen Anordnung), Mehrschichtanordnungen und dergleichen. Dabei sind für verschiedene Anwendungen unterschiedlichste Träger wie zum Beispiel Folien, mit den Klebemassen kombinierbar. Des Weiteren umfasst der Ausdruck "Klebeband" auch so genannte "Transferklebebänder", das heißt ein Klebeband ohne Träger. Bei einem Transferklebeband ist die Klebemasse vielmehr vor der Applikation zwischen flexiblen Linern aufgebracht, die mit einer Trennschicht versehen sind und/oder anti-adhäsive Eigenschaften aufweisen. Zur Applikation wird regelmäßig zunächst ein Liner entfernt, die Klebemasse appliziert und dann der zweite Liner entfernt. Die Klebemasse kann so direkt zur Verbindung zweier Oberflächen in (opto-) elektronischen Anordnungen verwendet werden.

Es sind aber auch Klebebänder möglich, bei denen nicht mit zwei Linern, sondern mit einem einzigen doppelseitig trennend ausgerüsteten Liner gearbeitet wird. Die Klebebandbahn ist dann an ihrer Oberseite mit der einen Seite eines doppelseitig trennend ausgerüsteten Liners abgedeckt, ihre Unterseite mit der Rückseite des doppelseitig trennend ausgerüsteten Liners, insbesondere einer benachbarten Windung auf einem Ballen oder einer Rolle.

Als Trägermaterial eines Klebebandes werden vorliegend bevorzugt Polymerfolien, Folienverbunde oder mit organischen und/oder anorganischen Schichten versehene Folien oder Folienverbunde eingesetzt. Derartige Folien/Folienverbunde können aus allen gängigen zur Folienherstellung verwendeten Kunststoffen bestehen, beispielhaft aber nicht einschränkend erwähnt seien: Polyethylen, Polypropylen - insbesondere das durch mono- oder biaxiale Streckung erzeugte orientierte Polypropylen (OPP), Cyclische Olefin Copolymere (COC), Polyvinylchlorid (PVC), Polyester - insbesondere Polyethylenterephthalat (PET) und Poylethylennaphtalat (PEN), Ethylenvinylalkohol (EVOH), Polyvinylidenchlorid (PVDC), Polyvinylidenfluorid (PVDF), Polyacrylnitril (PAN), Polycarbonat (PC), Polyamid (PA), Polyethersulfon (PES) oder Polyimid (PI).

Der Träger kann zudem mit organischen oder anorganischen Beschichtungen oder Schichten kombiniert sein. Dies kann durch übliche Verfahren wie zum Beispiel Lackieren, Drucken, Bedampfen, Sputtern, Co-Extrusion oder Lamination geschehen. Beispielhaft, aber nicht einschränkend erwähnt seien hier etwa Oxide oder Nitride des Siliziums und des Aluminiums, Indium-Zinn-Oxid (ITO) oder Sol-Gel-Beschichtungen.

Besonders bevorzugt sind diese Folien/Folienverbunde, insbesondere die Polymerfolien mit einer Permeationsbarriere für Sauerstoff und Wasserdampf versehen, wobei die Permeationsbarriere die Anforderungen für den Verpackungsbereich übertrifft (WVTR < 10⁻¹ g/(m²d); OTR < 10⁻¹ cm³/(m²d bar)). Zudem können die Folien/Folienverbunde in bevorzugter Ausgestaltung transparent ausgebildet sein, damit auch der Gesamtaufbau eines derartigen Klebeartikels transparent ausgebildet ist. "Transparenz" bedeutet auch hier eine mittlere Transmission im sichtbaren Bereich des Lichts von mindestens 75 %, bevorzugt höher als 90 %.

Bei doppelseitig (selbst)klebenden Klebebändern können als obere und untere Schicht erfindungsgemäße Klebemassen gleicher oder verschiedener Art und/oder gleicher oder verschiedener Schichtdicke zur Anwendung kommen. Der Träger kann dabei auf einer oder beiden Seiten dem Stand der Technik entsprechend vorbehandelt sein, so dass beispielsweise eine Verbesserung der Klebemassenverankerung erzielt wird. Ebenso können eine oder beide Seiten mit einer funktionalen Schicht ausgerüstet sein, die beispielsweise als Sperrschicht fungieren kann. Die Haftklebemasseschichten können optional mit Trennpapieren oder Trennfolien eingedeckt werden. Alternativ kann auch nur eine Klebemasseschicht mit einem doppelseitig trennenden Liner eingedeckt sein.

Des Weiteren sind die Klebemasse sowie ein eventuell damit gebildetes Klebeband hervorragend zur Kapselung einer elektronischen Anordnung gegen Permeanten geeignet, indem die Klebemasse oder das Klebeband auf und/oder um die zu kapselnden Bereiche der elektronischen Anordnung appliziert werden.

Als Kapselung wird vorliegend nicht nur ein vollumfänglicher Einschluss mit der genannten Haftklebemasse bezeichnet, sondern auch bereits eine bereichsweise Applikation der Haftklebemasse auf den zu kapselnden Bereichen der (opto-) elektronischen Anordnung, beispielsweise eine einseitige Überdeckung oder eine Umrahmung einer elektronischen Struktur.

Im Prinzip können mit Klebebändern zwei Arten der Verkapselung durchgeführt werden. Entweder wird das Klebeband zuvor ausgestanzt und nur um die zu kapselnden Bereiche herum verklebt, oder es wird vollflächig über die zu kapselnden Bereiche geklebt. Ein Vorteil der zweiten Variante ist die einfachere Handhabung und der häufig bessere Schutz.

Da es sich bei der Klebemasse vorzugsweise um eine Haftklebemasse handelt, ist die Applikation besonders einfach, da keine Vorfixierung erfolgen muss. Die Haftklebemassen erlauben eine flexible und saubere Verarbeitung.

Vorteil der hier vorliegenden Erfindung ist also im Vergleich zu anderen Haftklebemassen die Kombination aus sehr guten Barriereeigenschaften gegenüber Sauerstoff und vor allem gegenüber Wasserdampf bei gleichzeitiger guter Grenzflächenhaftung auf unterschiedlichen Substraten mit guten kohäsiven Eigenschaften.

Von besonderem Vorteil für die Verarbeitung der Klebemassen ist es, wenn diese vor, während oder nach der Applikation der Haftklebemasse erwärmt werden. Dadurch kann die Haftklebemasse noch besser auffließen und somit die Permeation an der Grenzfläche des Substrates und der Haftklebemasse weiter vermindert werden. Die Temperatur sollte dabei bevorzugt mehr als 30 °C, weiter bevorzugt mehr als 50 °C betragen, um das Auffließen entsprechend zu fördern. Erfindungsgemäß kann die Temperatur zur Trocknung und Vor- und Endvernetzung der Klebemasse über 100 °C, auch über 120 °C betragen.

Gegenstand der Erfindung ist gleichfalls ein Verfahren zur Herstellung einer Klebemasse sowie eine Klebemasse erhältlich nach dem Verfahren, insbesondere eine Klebemasse als Permeantenbarriere, indem (i) Blockcopolymere sowie Mischungen dieser, mit einem Aufbau A-B-A, (A-B)ₙ, (A-B)ₙX oder (A-B-A)ₙX, wobei X der Rest eines Kopplungsreagenzes ist, n eine ganze Zahl zwischen 2 und 10, A ein Polymerblock aus einem Vinylaromaten und B ein Polymerblock aus einem Alken oder Dien, wobei dieser Polymerblock auch hydriert sein kann, mit der Bedingung, dass zumindest ein Teil der A-Blöcke sulfoniert ist, optional als Zumischkomponente Zweiblockcopolymere der Form A-B, insbesondere unabhängig ein Copolymer mit A' ein Polymerblock aus einem Vinylaromaten und B' ein Polymerblock aus einem Alken oder Dien, und
(ii) mindestens ein Klebharz und optional
(iii) mindestens ein Metallkomplex mit einem substituierbaren Komplexbildner vermengt werden.

In einer bevorzugten Verfahrensvariante weist das Blockcopolymer A-Blöcke, abgeleitet aus Vinylaromaten; und B-Blöcke, abgeleitet aus Alkenen oder Dienen wie linearen oder verzweigten Alkenen oder Dienen mit 2 bis 8 C-Atomen, auf, wobei die B-Blöcke zumindest teilweise, bevorzugt vollständig hydriert sind, und wobei die Aromaten in den A-Blöcken teilweise sulfoniert werden. Als vollständig hydriert gilt ein Polymer, wenn der Gehalt an Doppelbindungen kleiner 5 Mol-% in Bezug auf Mol-% eingesetzte Monomere beträgt.

Ebenso ist Gegenstand der Erfindung die Verwendung einer erfindungsgemäßen Klebemasse sowie das Verfahrenserzeugnis vorgenannten Verfahrens, bei dem die Klebemasse vor einer Applikation teilvernetzt wird oder nach einer Applikation teil- oder endvernetzt wird, insbesondere durch Erwärmen der Klebemasse und/oder des Elementes vor, während oder nach der Applikation der Klebemasse auf dem Element. Eine erfindungsgemäße Klebemasse zusätzlich umfassend ein Epoxidharz kann vorzugsweise nach oder vor einer Applikation thermisch teilvernetzt werden und nach der Applikation thermisch und/oder mit UV-Licht endvernetzt werden.

Zudem ist auch die Verwendung einer Klebemasse oder eines mit der Klebemasse gebildeten ein- oder doppelseitig klebenden Klebebandes Gegenstand der Erfindung, insbesondere die Verwendung eines Klebebandes als Klebeverbund zur Ausbildung von Barriereschichten, vorzugsweise als Klebeband zur Ausbildung von temperaturstabilen Barriereschichten, insbesondere mit einem SAFT-Wert größer gleich 180 °C, insbesondere größer gleich 200 °C, als Barrieremasse zur Vermeidung der Diffusion von Permeanten, zur Kapselung einer elektronischen Anordnung, zur Kapselung einer optoelektronischen Anordnung.

Weitere Einzelheiten, Ziele, Merkmale und Vorteile der vorliegenden Erfindung werden nachfolgend anhand mehrerer, bevorzugte Ausführungsbeispiele darstellende Figuren näher erläutert. Es zeigen
- Fig. 1: eine erste (opto-)elektronische Anordnung in schematischer Darstellung,
- Fig. 2: eine zweite (opto-)elektronische Anordnung in schematischer Darstellung,
- Fig. 3: eine dritte (opto-)elektronische Anordnung in schematischer Darstellung.

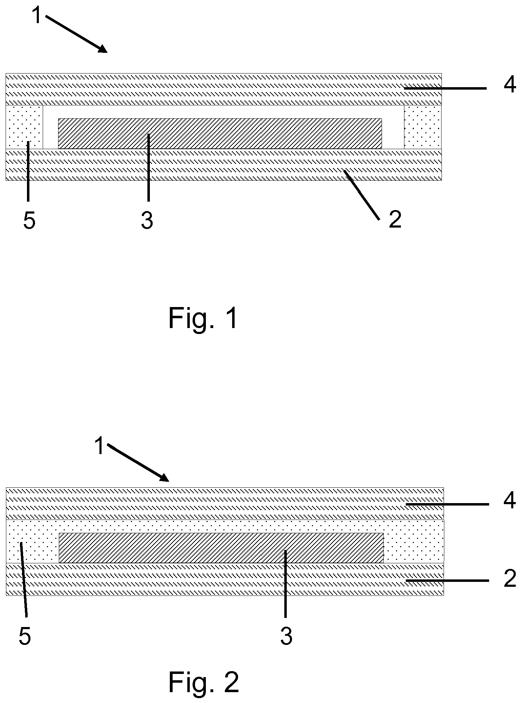

Fig. 1 zeigt eine erste Ausgestaltung einer (opto-)elektronischen Anordnung 1. Diese Anordnung 1 weist ein Substrat 2 auf, auf dem eine elektronische Struktur 3 angeordnet ist. Das Substrat 2 selbst ist als Barriere für Permeanten ausgebildet und bildet damit einen Teil der Kapselung der elektronischen Struktur 3. Oberhalb der elektronischen Struktur 3, vorliegend auch räumlich von dieser beabstandet, ist eine weitere als Barriere ausgebildete Abdeckung 4 angeordnet.

Um die elektronische Struktur 3 auch zur Seite hin zu kapseln und gleichzeitig die Abdeckung 4 mit der elektronischen Anordnung 1 im Übrigen zu verbinden, ist eine Haftklebemasse 5 umlaufend neben der elektronischen Struktur 3 auf dem Substrat 2 vorgesehen. In anderen Ausführungsformen erfolgt die Kapselung nicht mit einer reinen Haftklebemasse 5, sondern mit einem Klebeband 5, das zumindest eine erfindungsgemäße Haftklebemasse enthält. Die Haftklebemasse 5 verbindet die Abdeckung 4 mit dem Substrat 2. Durch eine entsprechend dicke Ausgestaltung ermöglicht die Haftklebemasse 5 zudem die Beabstandung der Abdeckung 4 von der elektronischen Struktur 3.

Bei der Haftklebemasse 5 handelt es sich um eine solche auf Basis der erfindungsgemäßen Haftklebemasse, wie sie vorstehend in allgemeiner Form beschrieben wurde und nachfolgend in Ausführungsbeispielen näher dargelegt ist. Die Haftklebemasse 5 übernimmt vorliegend nicht nur die Funktion des Verbindens des Substrats 2 mit der Abdeckung 4, sondern bildet zudem auch eine Barriereschicht für Permeantent, um so die elektronische Struktur 3 auch von der Seite gegen Permeanten wie Wasserdampf und Sauerstoff zu kapseln.

Die Haftklebemasse 5 wird vorliegend zudem in Form eines Stanzlings aus einem doppelseitigen Klebebandes bereitgestellt. Ein derartiger Stanzling ermöglicht eine besonders einfache Applikation.

Fig. 2 zeigt eine alternative Ausgestaltung einer (opto-)elektronischen Anordnung 1. Gezeigt ist wiederum eine elektronische Struktur 3, die auf einem Substrat 2 angeordnet und durch das Substrat 2 von unten gekapselt ist. Oberhalb und seitlich von der elektronischen Struktur ist nun die Haftklebemasse 5 vollflächig angeordnet. Die elektronische Struktur 3 wird somit von oben vollständig durch die Haftklebemasse 5 gekapselt. Auf die Haftklebemasse 5 ist sodann eine Abdeckung 4 aufgebracht. Diese Abdeckung 4 muss im Gegensatz zu der vorherigen Ausgestaltung nicht zwingend die hohen Barriereanforderungen erfüllen, da die Barriere bereits durch die Haftklebemasse bereitgestellt wird. Die Abdeckung 4 kann beispielsweise lediglich eine mechanische Schutzfunktion wahrnehmen, sie kann aber auch zusätzlich als Permeationsbarriere vorgesehen sein.

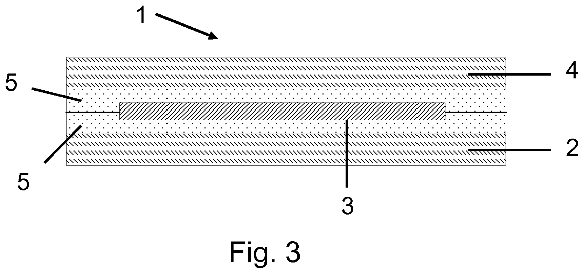

Fig. 3 zeigt eine weitere alternative Ausgestaltung einer (opto-)elektronischen Anordnung 1. Im Gegensatz zu den vorherigen Ausgestaltungen sind nun zwei Haftklebemassen 5a, 5b vorgesehen, die vorliegend identisch ausgebildet sind. Die erste Haftklebemasse 5a ist vollflächig auf dem Substrat 2 angeordnet. Auf der Haftklebemasse 5a ist die elektronische Struktur 3 vorgesehen, die durch die Haftklebemasse 5a fixiert wird. Der Verbund aus Haftklebemasse 5a und elektronischer Struktur 3 wird dann mit der weiteren Haftklebemasse 5b vollflächig überdeckt, so dass die elektronische Struktur 3 von allen Seiten durch die Haftklebemassen 5a, b gekapselt ist. Oberhalb der Haftklebemasse 5b ist wiederum die Abdeckung 4 vorgesehen.

In dieser Ausgestaltung müssen somit weder das Substrat 2 noch die Abdeckung 4 zwingend Barriereeigenschaften aufweisen. Sie können aber dennoch vorgesehen sein, um die Permeation von Permeanten zur elektronischen Struktur 3 weiter einzuschränken.

Insbesondere im Hinblick auf die Fig. 2, 3 wird darauf hingewiesen, dass es sich vorliegend um schematische Darstellungen handelt. Aus den Darstellungen ist insbesondere nicht ersichtlich, dass die Haftklebemasse 5 hier und vorzugsweise jeweils mit einer homogenen Schichtdicke aufgetragen wird. Am Übergang zur elektronischen Struktur bildet sich daher keine scharfe Kante, wie es in der Darstellung scheint, sondern der Übergang ist fließend und es können vielmehr kleine un- oder gasgefüllte Bereiche verbleiben. Gegebenenfalls kann jedoch auch eine Anpassung an den Untergrund erfolgen, insbesondere dann, wenn die Applikation unter Vakuum oder unter erhöhtem Druck durchgeführt wird. Zudem wird die Haftklebemasse lokal unterschiedlich stark komprimiert, so dass durch Fließprozesse ein gewisser Ausgleich der Höhendifferenz an den Kantenstrukturen erfolgen kann. Auch die gezeigten Dimensionen sind nicht maßstäblich, sondern dienen vielmehr nur einer besseren Darstellung. Insbesondere die elektronische Struktur selbst ist in der Regel relativ flach ausgebildet (oft weniger als 1 µm dick).

Die Applikation der Haftklebemasse 5 erfolgt in allen gezeigten Ausführungsbeispielen in Form eines Haftklebebandes. Dabei kann es sich grundsätzlich um ein doppelseitiges Haftklebeband mit einem Träger oder um ein Transferklebeband handeln. Vorliegend ist eine Ausgestaltung als Transferklebeband gewählt.

Die Dicke der Haftklebemasse, die entweder als Transferklebeband oder auf einem flächigen Gebilde beschichtet vorliegt, beträgt bevorzugt zwischen etwa 1 µm und etwa 150 µm, weiter bevorzugt zwischen etwa 5 µm und etwa 75 µm und besonders bevorzugt zwischen etwa 12 µm und 50 µm. Hohe Schichtdicken zwischen 50 µm und 150 µm werden dann eingesetzt wenn eine verbesserte Haftung auf dem Substrat und/oder eine dämpfende Wirkung innerhalb des (opto-)elektronischen Aufbaus erreicht werden soll. Nachteilig ist hier jedoch der erhöhte Permeationsquerschnitt. Geringe Schichtdicken zwischen 1 µm und 12 µm reduzieren den Permeationsquerschnitt, damit die laterale Permeation und die Gesamtdicke des (opto-)elektronischen Aufbaus. Jedoch kommt es zu einer Verringerung der Haftung aus dem Substrat. In den besonders bevorzugten Dickenbereichen liegt ein guter Kompromiss zwischen einer geringen Massendicke und dem daraus folgenden niedrigen Permeationsquerschnitt, der die laterale Permeation verringert, und einem genügend dicken Massefilm zur Herstellung einer ausreichend haftenden Verbindung. Die optimale Dicke hängt vom (opto-)elektronischen Aufbau, der Endanwendung, der Art der Ausführung der Haftklebemasse und gegebenenfalls dem flächigen Substrat ab.

Für doppelseitige Klebebänder gilt für die Barriereklebemasse(n) ebenfalls, dass die Dicke der einzelnen Haftklebemasseschicht(en) bevorzugt zwischen etwa 1 µm und etwa 150 µm, weiter bevorzugt zwischen etwa 5 µm und etwa 75 µm und besonders bevorzugt zwischen etwa 12 µm und 50 µm liegt. Kommt in doppelseitigen Klebebändern neben der einen erfindungsgemäßen Barriereklebemasse eine weitere zum Einsatz, dann kann es auch vorteilhaft sein, wenn ihre Dicke oberhalb 150 µm liegt.

Im Folgenden wird die Erfindung durch einige Beispiele näher erläutert, ohne die Erfindung damit einschränken zu wollen.

### Prüfmethoden

**Glasübergangspunkt (T_{g})** - Die Bestimmung des Glasübergangspunkts (T_{g}) von Polymeren und Copolymeren kann über Dynamische Differenz Kalorimetrie durchgeführt werden, so wie sie in DIN 53765 beschrieben wird. Hierzu werden 7 mg der Probe in einen Aluminiumtiegel genau eingewogen und anschließend in das Messgerät (Gerät: DSC 204 F1, Firma Netzsch) eingebracht. Als Referenz wird ein leerer Tiegel benutzt. Anschließend werden zwei Aufheizkurven mit einer Aufheizrate von 10 K/min aufgenommen. Der T_{g} wird aus der zweiten Aufheizkurve ermittelt. Die Auswertung erfolgt über die Gerätesoftware.

**Klebkraft** - Die Bestimmung der Klebkraft wurde wie folgt durchgeführt: Als definierter Haftgrund wurden Glasplatten (Floatglas) eingesetzt. Das zu untersuchende verklebbare Flächenelement wurde auf eine Breite von 20 mm und eine Länge von etwa 25 cm zugeschnitten, mit einem Handhabungsabschnitt versehen und unmittelbar danach fünfmal mit einer Stahlrolle von 4 kg bei einem Vorschub von 10 m/min auf den jeweils gewählten Haftgrund aufgedrückt. Unmittelbar im Anschluss daran wurde das zuvor verklebte Flächenelement in einem Winkel von 180° bei Raumtemperatur und mit 300 mm/min vom Haftgrund mit einem Zugprüfungsgerät (Firma Zwick) abgezogen und die hierfür benötigte Kraft gemessen. Der Messwert (in N/cm) ergab sich als Mittelwert aus drei Einzelmessungen. Die Prüfung erfolgte an unvernetzten Mustern.

**Shear Adhesion Failure Temperature (SAFT)** - Die Bestimmung der SAFT wurde wie folgt durchgeführt: Als definierter Haftgrund wurde eine polierte Stahlfläche eingesetzt. Das zu untersuchende verklebbare Flächenelement wurde auf eine Breite von 10 mm und eine Länge von etwa 5 cm zugeschnitten und unmittelbar danach dreimal mit einer Stahlrolle von 2 kg bei einem Vorschub von 10 m/min auf den jeweils gewählten Haftgrund mit einer Fläche von 10 x 13 mm aufgedrückt. Unmittelbar im Anschluss daran wurde das zuvor verklebte Flächenelement in einem Winkel von 180° mit 0,5 N belastet und eine Temperaturrampe von 9 °C/min gefahren. Dabei wurde die Temperatur gemessen, bei der die Probe eine Rutschstrecke von 1 mm zurückgelegt hat. Der Messwert (in °C) ergibt sich als Mittelwert aus zwei Einzelmessungen.

**Permeabilität für Sauerstoff (OTR) und Wasserdampf (WVTR)** - Die Bestimmung der Permeabilität für Sauerstoff (OTR) und Wasserdampf (WVTR) erfolgt nach DIN 53380 Teil 3 beziehungsweise ASTM F-1249. Die Haftklebemasse wird dazu mit einer Schichtdicke von 50 µm auf eine permeable Membran aufgebracht. Die Sauerstoffdurchlässigkeit wird bei 23 °C und einerrelativen Feuchte von 50 % gemessen mit einem Messgerät Mocon OX-Tran 2/21. Die Wasserdampfdurchlässigkeit wird bei 37,5 °C und einer relativen Feuchte von 90 % bestimmt.

**Transmission** - Die Transmission der Klebemasse wurde über das VIS-Spektrum bestimmt. Die Aufnahmen des VIS-Spektrums wurden an einem UVIKON 923 der Firma Kontron durchgeführt. Der Wellenlängenbereich des gemessenen Spektrums umfasst alle Wellenlängen zwischen 800 nm und 400 nm bei einer Auflösung von 1 nm. Es wurde eine Leerkanalmessung als Referenz über den gesamten Wellenlängenbereich durchgeführt. Für die Angabe des Ergebnisses wurden die Transmissionsmessungen im angegebenen Bereich gemittelt. Eine Korrektur von Grenzflächenreflexionsverlusten wird nicht vorgenommen. (T%: Transmission, korrigiert um Reflexionswerte)

**Molekulargewicht** - Die Bestimmung des mittleren Molekulargewichtes Mw (Gewichtsmittel) erfolgt mittels Gelpermeationschromatographie (GPC). Als Eluent wird THF mit 0,1 Vol.-% Trifluoressigsäure eingesetzt. Die Messung erfolgt bei 25 °C. Als Vorsäule wird PSS-SDV, 5 µm, 10³ Ä, ID 8,0 mm x 50 mm verwendet. Zur Auftrennung wurden die Säulen PSS-SDV, 5 µm, 10³ Å, 10⁵ Å und 10⁶ Ä mit jeweils ID 8,0 mm × 300 mm eingesetzt. Die Probenkonzentration beträgt 4 g/l, die Durchflussmenge 1,0 ml pro Minute. Es wird gegen PS-Standards gemessen.

**Biegetest** - Für die Bestimmung der Flexibilitaet wurde die Klebemasse in einer Schichtdicke von 50 µm zwischen zwei 23 µm PET-Trägern beschichtet und auf einen Biegeradius von 1 mm bei einer Biegung von 180° geprüft. Bestanden ist der Test, falls es nicht zum Bruch oder Ablösen der Schicht kommt.

**Blasentest** - Die Klebefolie wird auf eine mit einer anorganischen Barriereschicht versehenen PET- Barrierefolie mit einer Dicke von 25 µm (WVTR@38 °C/90 %rF = 8×10⁻² g/m^{2*}d und OTR@23 °C/50 %rF = 6×10² cm3/m^{2*}d^{*}bar, entsprechend nach ASTM F-1249 und DIN 53380 Teil 3 und oben genannten Bedingungen) verklebt und bei Raumtemperatur (23 °C) mit einer Gummirolle aufgerdlt. Anschließend wird die zweite Seite der Klebemasse mit derselben Folie blasenfrei verklebt und ebenfalls angerollt. Nach einer Aufziehzeit von 24 h wird das präparierte Muster bei 85 °C und 85 %rF für 20 Stunden gelagert. Untersucht wird, ob und wann in dem Verbund Blasen entstehen, sowohl die Anzahl der Blasen pro cm² als auch deren mittlere Größe wird bestimmt. Es wird die Dauer bis zum Erscheinen erster Blasen vermerkt.

### Beispiele:

### Allgemeine Herstellbeispiele Sulfonierung:

Nachfolgend werden allgemeine Beispiele für mögliche Sulfonierungsverfahren dargestellt:
a) Es wird eine 10 % (w/v) Lösung von SIBS (50 g) in Methylenchlorid (500 ml) hergestellt. Die Lösung wird gerührt und unter Rückfluss in Stickstoffatmosphäre auf etwa 40°C erwärmt. Acetylsulfat als Sulfonierungsagenz wrd in Methylenchlorid hergestellt. Hierzu werden 150 ml Methylenchlorid in einem Eis-Bad vorbereitet. Anschließend wird entsprechend des gewünschten Sulfonierungsgrades Essigsäureanhydrid vorgelegt. Das Essigsäureanhydrid wird mit einem 1,5:1-molaren Verhältnis zur konzentrierten Schwefelsäure im Überschuss hinzugefügt. Die konzentrierte Schwefelsäure wird anschließend langsam über einen Tropftrichter unter Rühren zugegeben. Die Mischung wird dann ca. 10 Minuten homogenisiert. Hierbei darf keine Färbung auftreten. Die Acetylsulfat-Lösung wird dann ihrerseits in einen Tropftrichter umgefüllt und während 10 bis 30 Minuten langsam zur warmen Polymerlösung hinzugetropft. Nach ca. 5 h beendet man die Reaktion durch langsame Zugabe von 100 ml Methanol. Die umgesetzte Polymerlösung wird dann in deionisiertem Wasser ausgefällt. Der Niederschlag wird mehrmals mit Wasser gewaschen und anschließend in einem Vakuumofen bei 50 °C für 24 h getrocknet.
b) Aus der US 3,642,953 A ist das nachfolgende Verfahren abgeleitet: SIBS als Block-Polymer mit mittleren Block-Molekulargewichten 10,000-127,000-10, 000 (14,3 g) wurde in trockenem Diethylether gelöst (1.000 g), gefiltert und auf 0 °C gekühlt. Zur Polymerlösung wurde langsam eine Mischung aus 8,8 g Chlorsulfonsäure, aufgenommen in 100 g trockenem Diethylether, hinzugefügt. Die Reaktionstemperatur wurde bei 0 °C bis 5 °C für 30 Minuten gehalten. Dabei fällt das Fblymer aus der Lösung aus und Chlorwasserstoff entsteht. Am Ende der Reaktionszeit wurde das Gemisch auf Raumtemperatur erwärmt, der Ether wurde aus dem Produkt dekantiert und das ausgefällte Produkt wurde dreimal mit Ether gewaschen. Die beiden vorgenannten Verfahren sind gegebenenfalls mit Modifikation grundsätzlich auf alle erfindungsgemäßen Sulfonierungen anwendbar. Gegenstand der Erfindung sind auch Copolymere umfassend sulfonierte Copolymere erhältlich nach den vorgenannten Verfahren im Gemische mit unsulfonierten Copolymeren.

**Herstellung der Muster** - Die Haftklebemassen in Beispiel 1 bis 3 wurden aus Lösung hergestellt. Dazu wurden die einzelnen Bestandteile in THF/Toluol/Methanol 80/10/10 gelöst (Feststoffanteil 40 %) und auf eine unbehandelte 23 µm PET-Folie beschichtet und bei 120 °C 15 Minuten lang getrocknet, so dass eine Klebemasseschicht mit einem Flächengewicht von 50 g/m² entstand.

**Beispiel 1:** Es wird eine 10 % (w/v) Lösung von SIBS Sibstar 103T (50 g) in Methylenchlorid (500 ml) hergestellt. Die Lösung wird gerührt und unter Rückfluss in Stickstoffatmosphäre auf etwa 40 °C erwärmt. Acetylsulfat als Sulfonierungsagenz wird in Methylenchlorid hergestellt. Hierzu werden 150 ml Methylenchlorid in einem Eis-Bad vorbereitet. Anschließend wird entsprechend 2,57 g Essigsäureanhydrid vorgelegt. Das Essigsäureanhydrid wird zur konzentrierten Schwelsäure im Überschuss hinzugefügt. 1,41 g der konzentrierten Schwefelsäure wird anschließend langsam über einen Tropftrichter unter Rühren zugegeben. Die Mischung wird dann ca. 10 Minuten homogenisiert. Hierbei darf keine Färbung auftreten. Die Acetylsulfat-Lösung wird dann während 10 bis 30 Minuten langsam zur warmen Polymerlösung hinzu getropft. Nach ca. 5 h beendet man die Reaktion durch langsame Zugabe von 100 ml Methanol. Die umgesetzte Polymerlösung wird dann in kaltem Methanol ausgefällt. Der Niederschlag wird mehrmals mit Methanol und Wasser gewaschen und anschließend in einem Vakuumofen bei 80 °C für 24 h getrocknet. Der Sulfonsäureanteil eines so hergestellten Polymers liegt bei ~7 Mol-%.

### Masse - Beispiel 1

| | | |
|---|---|---|
| 100 Teile | SiBStar 103T | Triblock-SiBS mit 30 Gew.-% Blockpolystyrolgehalt der Firma Kaneka sulfoniert 7 Mol-% |
| 30 Teile | SiBStar 042D | Diblock-SiB mit 15 Gew.-% Blockpolystyrolgehalt der Firma Kaneka |
| 130 Teile | Regalite 1090 | Hydriertes KW-Harz mit einem Erweichungspunkt von 90 °C der Firma Eastman |
| 30 Teile | Ondina G 17 | Weißöl aus parafinischen und naphtenischen Anteilen der Firma Shell |
| 3 Teile | | Aluminiumacetylacetonat |
| 2 Teile | | Pentandion |

### Beispiel 2

| | | |
|---|---|---|
| 50 Teile | Kraton G652 M | SEBS (Styrol-Ethylen-Butylen-Styrol) mit 30 Gew.-% Blockpolystyrolgehalt der Firma Kraton sulfoniert 7 Mol-% |
| 50 Teile | Kraton G1657 M | SEBS mit 13 Gew.-% Blockpolystyrolgehalt der Firma Kraton und einem Diblockanteil von 29 Mol-% |
| 70 Teile | Escorez 5600 | Hydriertes KW-Harz mit einem Erweichungspunkt von 100 °C der Firma Exxon |
| 25 Teile | Ondina G 17 | Weißöl aus parafinischen und naphtenischen Anteilen der Firma Shell |
| 2,5 Teile | | Aluminiumacetylacetonat |
| 2,5 Teile | | Pentandion |

### Beispiel 3

| | | |
|---|---|---|
| 50 Teile | Septon 4033 | Triblock SEEPS (Styrol-Ethylen/(Ethylen-Propylen)-Styrol) mit 30 Gew.-% Blockpolystyrolgehalt der Firma Kuraray sulfoniert mit 7 Mol-% |
| 50 Teile | Septon 2063 | Triblock SEPS mit 13 Gew.-% Blockpolystyrolgehalt der Firma Kuraray |
| 120 Teile | Foral 85 | Hydriertes Kolophoniumharz mit einem Erweichungspunkt von 85 °C der Firma Eastman |
| 10 Teile | Wingtack 10 | Weichharz der Firma Cray Valley |
| 1 Teil | | Aluminiumacetylacetonat |
| 1 Teil | | Pentandion |

### Masse - Vergleichsbeispiel 1

| | | |
|---|---|---|
| 100 Teile | SiBStar 103T | Triblock-SiBS mit 30 Gew.-% Blockpolystyrolgehalt der Firma Kaneka |
| 30 Teile | SiBStar 042D | Diblock-SiB mit 15 Gew.-% Blockpolystyrolgehalt der Firma Kaneka |
| 130 Teile | Regalite 1090 | Hydriertes KW-Harz mit einem Erweichungspunkt von 90 °C der Firma Eastmann |
| 30 Teile | Ondina G 17 | Weißöl aus parafinischen und naphtenischen Anteilen der Firma Shell |

### Vergleichsbeispiel 2

| | | |
|---|---|---|
| 50 Teile | Kraton G 1652M | Triblock SEBS mit 30 Gew.-% Blockpolystyrolgehalt der Firma Kraton |
| 50 Teile | Kraton G 1657 | SEBS mit 13 Gew.-% Blockpolystyrolgehalt der Firma Kraton. Das SEBS wies einen Zweiblockgehalt von ca. 36 Mol-% auf. |
| 70 Teile | Escorez 5600 | Hydriertes KW-Harz mit einem Erweichungspunkt von 100 °C der Firma Exxon |
| 25 Teile | Ondina G 17 | Weißöl aus parafinischen und naphtenischen Anteilen der Firma Shell |

### Vergleichsbeispiel 3

| | | |
|---|---|---|
| 50 Teile | Septon 4033 | Triblock SEEPS (Styrol-Ethylen/(Ethylen-Propylen)-Styrol) mit 30 Gew.-% Blockpolystyrolgehalt der Firma Kuraray |
| 50 Teile | Septon 2063 | Triblock SEPS mit 13 Gew.-% Blockpolystyrolgehalt der Firma Kuraray |
| 120 Teile | Foral 85 | Hydriertes Kolophoniumharz mit einem Erweichungspunkt von 85 °C der Firma Eastman |
| 10 Teile | Wingtack 10 | Weichharz der Firma Cray Valley |

**Tabelle 1: Ausprüfung der Beispiele**

| | **Klebkraft** | **SAFT** | **T%** | **Blasentest** | **WVTR** | **OTR** | **Biegetest** |
|---|---|---|---|---|---|---|---|
| Beispiel 1 | 5,5 | 210 | 90 | <10/cm² | 9,7 | 2600 | bestanden |
| Beispiel 2 | 6,4 | 210 | 88 | <10/cm² | 93 | 6930 | bestanden |
| Beispiel 3 | 4,7 | 210 | 88 | <10/cm² | 42 | 3000 | bestanden |
| Vergleichsbeispiel 1 | 3,8 | 120 | 90 | >100/cm² | 8,7 | 3000 | bestanden |
| Vergleichsbeispiel 2 | 4,2 | 110 | 88 | >100/cm² | 89 | 7280 | bestanden |
| Vergleichsbeispiel 3 | 3,9 | 105 | 88 | >100/cm² | 73 | 6000 | bestanden |

Wie in der vorstehenden Tabelle zu sehen ist, nehmen die Haftung der sulfonierten Klebemasse auf polaren Untergründen und die Temperaturscherfestigkeit zu. Die Messung wurde bei 210 °C beendet, da dies das Maxirrum der Temperiereinheit darstellt. Im Gegensatz dazu zeigen die unvernetzten Systeme das für Styrolblockcopolymer typische Temperaturversagen zwischen 100 °C bis 120 °C, welches sich durch das Erweichen der Styroldomänen ergibt. Der unpolare Charakter herrscht bei diesen Klebemassen vor, wodurch sich die etwas schlechtere Klebkraft auf Stahl zeigt. Wie zu erkennen ist, konnten in allen Beispielen auf allen Untergründen ausreichende Klebkräfte und bei den Beispielen 1, 2 und 3 exzellente Beständigkeit bei erhöhten Temperaturen erreicht werden.

Wie zu erkennen ist, ist die Sperrwirkung der Sofortklebebänder aus den ersten beiden Beispielen sogar etwas besser als beim Vergleichsbeispiel V1 und V2, wobei die Transmission im sichtbaren Bereich des Lichts ähnlich ist. Ersteres ist für den Fachmann überraschend, da durch die Funktionalisierung die Polarität der Massen steigt und somit zumindest die WVTR gegenüber der unpolaren Vergleichsklebemasse höher sein sollte. Zusätzlich ist die Tendenz bei Feuchtetemperaturlagerungen (60 °C/95 %rF) Blasen zu entwickeln bei der vernetzen Klebemasse deutlich reduziert.

### Masse - Beispiel 4

| | | |
|---|---|---|
| 100 Teile | SiBStar 103T | Triblock-SiBS mit 30 Gew.-% Blockpolystyrolgehalt der Firma Kaneka sulfoniert mit 4 Mol-% |
| 30 Teile | SiBStar 042D | Diblock-SiB mit 15 Gew.-% Blockpolystyrolgehalt der Firma Kaneka |
| 130 Teile | Regalite 1090 | Hydriertes KW-Harz mit einem Erweichungspunkt von 90 °C der Firma Eastmann |
| 30 Teile | Ondina G 17 | Weißöl aus parafinischen und naphtenischen Anteilen der Firma Shell |
| 1 Teil | | Aluminiumacetylacetonat |
| 1 Teil | | Pentandion |

### Beispiel 5

| | | |
|---|---|---|
| 50 Teile | Kraton G 1652M | Triblock SEBS mit 30 Gew.-% Blockpolystyrolgehalt der Firma Kraton sulfoniert mit 4 Mol-% |
| 50 Teile | Kraton G 1657 | SEBS mit 13 Gew.-% Blockpolystyrolgehalt der Firma Kraton. Das SEBS wies einen Zweiblockgehalt von ca. 36 Mol-% auf. |
| 70 Teile | Escorez 5600 | Hydriertes KW-Harz mit einem Erweichungspunkt von 100 °C der Firma Exxon |
| 25 Teile | Ondina G 17 | Weißöl aus parafinischen und naphtenischen Anteilen der Firma Shell |
| 1 Teil | | Aluminiumacetylacetonat |
| 1 Teil | | Pentandion |

### Beispiel 6

| | | |
|---|---|---|
| 30 Teile | Kraton G 1652M | Triblock SEBS mit 30 Gew.-% Blockpolystyrolgehalt der Firma Kraton sulfoniert mit 4 Mol-% |
| 30 Teile | Epikote 862 | Bisphenol-A-Epoxidharz mit einem Epoxidequivalent von 172 der Firma Hexion |
| 30 Teile | Regalite 1090 | Hydriertes KW-Harz mit einem Erweichungspunkt von 90 °C der Firma Eastmann |
| 1 Teile | Photoinitiator | Bis(4-tert-butylphenyl)iodonium hexafluorophosphate Sigma Aldrich |
| 1 Teil | | Aluminiumacetylacetonat |
| 1 Teil | | Pentandion |

### Vergleichsbeispiel 4

| | | |
|---|---|---|
| 30 Teile | Kraton G 1652M | Triblock SEBS mit 30 Gew.-% Blockpolystyrolgehalt der Firma Kraton |
| 30 Teile | Epikote 862 | Bisphenol-A-Epoxidharz mit einem Epoxidequivalent von 172 der Firma Hexion |
| 30 Teile | Regalite 1090 | Hydriertes KW-Harz mit einem Erweichungspunkt von 90 °C der Firma Eastmann |
| 1 Teile | Photoinitiator | Bis(4-tert-butylphenyl)iodonium hexafluorophosphate Sigma Aldrich |

**Tabelle 2: Ausprüfung der Beispiele**

| | Klebkraft | SAFT | T% | Blasentest | WVTR | OTR | Biegetest |
|---|---|---|---|---|---|---|---|
| Beispiel 4 | 5,1 | 210 | 90 | <10/cm² | 9,7 | 2600 | bestanden |
| Beispiel 5 | 5,9 | 210 | 88 | <10/cm² | 93 | 6930 | bestanden |
| Beispiel 6 | 1,4 | 210 | 88 | <10/cm² | 7 | 300 | bestanden |
| Vergleichsbeispiel 4 | 1,5 | 210 | 88 | <10/cm² | 8 | 600 | bestanden |

Die Werte der Beispiele 6 und Vergleichsbeispiel 4 sind aufgenommen nach einer UV-Härtung mit einem Conveyor belt system: Quecksilberdampflampe, 80mJ/cm², 10 m/min, 160 W/cm.

### Beispiel 7

| | | |
|---|---|---|
| 100 Teile | SiBStar M62 (sulfoniert) | SiBS mit 30 Gew.% Blockpolystyrolgehalt der Firma Kaneka sulfoniert mit 16 Mol-% |
| 100 Teile | Regalite 1090 | Hydriertes KW-Harz mit einem Erweichungspunkt von 90 °C der Firma Eastmann |
| 20 Teile | Ondina G 17 | Weißöl aus parafinischen und naphtenischen Anteilen der Firma Shell |

### Vergleichsbeispiel 5

| | | |
|---|---|---|
| 100 Teile | SiBStar M62 | SiBS mit 30 Gew.% Blockpolystyrolgehalt der Firma Kaneka |
| 100 Teile | Regalite 1090 | Hydriertes KW-Harz mit einem Erweichungspunkt von 90 °C der Firma Eastmann |
| 20 Teile | Ondina G 17 | Weißöl aus parafinischen und naphtenischen Anteilen der Firma Shell |

**Tabelle 3: Ausprüfung des Beispiels 7 und des Vergleichsbeispiels 5**

| | **Klebkraft** | **SAFT** | **T%** | **Blasentest** | **WVTR** | **OTR** | **Biegetest** |
|---|---|---|---|---|---|---|---|
| Beispiel 7 | 3,5 | 150 | 90 | <10/cm2 | 12 | 2100 | bestanden |
| Vergleichsbeispiel 5 | 3,2 | 90 | 89 | >100/cm² | 9 | 3000 | bestanden |

## Patentansprüche

1. Klebemasse, insbesondere als Permeantenbarriere, **dadurch gekennzeichnet, dass** die Klebemasse umfasst
(i) Blockcopolymere sowie Mischungen dieser, mit einem Aufbau A-B-A, (A-B)ₙ, (A-B)ₙX oder (A-B-A)ₙX wobei X der Rest eines Kopplungsreagenzes ist, n eine ganze Zahl zwischen 2 und 10, A ein Polymerblock aus einem Vinylaromaten und B ein Polymerblock aus einem Alken oder Dien ist, und wobei ein Teil der A-Blöcke sulfoniert ist, optional als Zumischkomponente Zweiblockcopolymere der Form A-B, und
(ii) mindestens ein Klebharz.

2. Klebemasse nach Anspruch 1, **dadurch gekennzeichnet, dass** das B ein hydrierter Polymerblock aus einem Alken oder Dien ist.

3. Klebemasse nach Anspruch 1 oder 2, **dadurch gekennzeichnet, dass** ein Teil der Blockcopolymere als sulfonierte Copolymere vorliegen und sulfonierte A-Blöcke aufweisen, deren Aromaten zwischen größer gleich 0,5 Mol-%, insbesondere zu größer gleich 0,5 bis 20 Mol-% je Mol der Monomereinheit bezogen auf die Gesamtmonomereinheiten der A-Blöcke im sulfonierten Copolymer sulfoniert sind, insbesondere größer gleich 0,5 bis 15 Mol-%.

4. Klebemasse nach einem der Ansprüche 1 bis 3, **dadurch gekennzeichnet, dass** sie ferner (iii) mindestens einen Metallkomplex mit einem substituierbaren Komplexbildner umfasst.

5. Klebemasse nach einem der Ansprüche 1 bis 4, **dadurch gekennzeichnet, dass** die Zumischkomponente ein Zweiblockcopolymer der Form A-B, ein Copolymer mit Polymerblöcken A' aus Vinylaromaten und Polymerblöcken B' aus einem Alken oder Dien ist.

6. Klebemasse nach einem der Ansprüche 1 bis 5, **dadurch gekennzeichnet, dass** (i) die A-Blöcke jeweils unabhängig einen T_{g} größer 40 °C und die B-Blöcke jeweils unabhängig einen T_{g} kleiner 0 °C aufweisen.

7. Klebemasse nach einem der Ansprüche 1 bis 6, **dadurch gekennzeichnet, dass** die B-Blöcke unabhängig Homo- oder Copolymere aus Monomeren ausgewählt sind aus Ethylen, Propylen, 1,3-Dienen sind, insbesondere aus Butadien und/oder Isopren.

8. Klebemasse nach einem der Ansprüche 1 bis 7, **dadurch gekennzeichnet, dass** die B-Blöcke zumindest teilweise hydriert, insbesondere im Wesentlichen vollständig hydriert sind.

9. Klebemasse nach einem der Ansprüche 1 bis 8; **dadurch gekennzeichnet, dass** die A-Blöcke unabhängig Homo- oder Copolymere aus Monomeren ausgewählt sind aus mit mindestens einem Vinylaromat wie Styrol, Styrol-Derivate und/oder α-Methylstryrol.

10. Klebemasse nach einem der Ansprüche 4 bis 9, **dadurch gekennzeichnet, dass** der Metallkomplex mit einem substituierbaren Komplexbildner einem Metallchelat der Formel I entspricht,
(R¹O)ₙM (XR²Y)ₘ (I)
wobei M ein Metall ausgewählt ist aus Metallen der 2. 3. 4. und 5. Hauptgruppe des Periodensystems der Elemente und den Übergangsmetallen, insbesondere ist M ausgewählt aus Aluminium, Zinn, Titan; Zirkonium, Hafnium, Vanadium, Niob, Chrom, Mangan, Eisen, Kobalt, und Cer, wobei M besonders bevorzugt Aluminium oder Titan, und
R¹ eine Alkyl- oder Aryl-Gruppe ist, insbesondere mit 1 bis 12 C-Atomen, wie Methyl, Ethyl, Butyl, Isopropyl oder Benzyl;
n gleich 0 oder eine größere ganze Zahl ist, insbesondere 0, 1, 2, 3 oder 4,
X und Y im Chelat-Ligand (XR²Y) unabhängig Sauerstoff oder Stickstoff sind, die optional mit einer Doppelbindung an R² gebunden sind,
R² eine X und Y verbindende Alkylen-Gruppe ist, die linear oder verzweigt ist, und optional mit Heteroatom(en) in der Alkylen-Gruppe, insbesondere Sauerstoff, Stickstoff oder Schwefel;
m eine ganze Zahl ist, mindestens jedoch 1, insbesondere eine Zahl ausgewählt aus 1, 2 oder 3.

11. Klebemasse nach Anspruch 10, **dadurch gekennzeichnet, dass** der Chelat-Ligand im Metallchelat aus der Reaktion mindestens einer der Verbindungen ausgewählt aus Triethanolamin, 2,4-Pentandion, 2-Ethyl-1,3-Hexandiol oder Milchsäure gebildet wird.

12. Klebemasse nach einem der Ansprüche 1 bis 11, **dadurch gekennzeichnet, dass**
(ii) zu 10 bis 70 Gew.-% mindestens ein Klebharz, insbesondere ein Kohlenwasserstoffharz, das vorzugsweise im Wesentlichen vollständig hydriert ist, und/oder ein Epoxidharz, und
(iii) mindestens ein Metallkomplex mit einem substituierbaren Komplexbildner und optional
(iv) bis zu 20 Gew.-% ein Weichmacher und
(v) 0,0 bis 20 Gew.-% Füllstoffe, Additive, Photoinitiatoren, Beschleuniger und/oder Härter,
(vi) bis zu 60 Gew.-% ein Reaktivharz, insbesondere 5 bis 40 Gew.-%, und (i) die Blockcopolymere und/oder Mischungen umfassend diese ad 100 Gew.-% in der Gesamtzusammensetzung der Klebemasse enthalten sind, vorzugsweise zu größer gleich 25 bis 80 Gew.-%.

13. Klebemasse nach einem der Ansprüche 8 bis 12, **dadurch gekennzeichnet, dass** der Anteil in Gew.-% der Vinylaromaten der A-Blöcke im (i) Copolymer in Bezug auf die Gesamtzusammensetzung der Klebemasse mindestens 20 bis 85 Gew.-% beträgt, vorzugsweise 20 bis 80 Gew.-%, besonders bevorzugt zwischen größer gleich 30 bis kleiner gleich 65 Gew.-%.

14. Klebemasse nach einem der Ansprüche 1 bis 13 **dadurch gekennzeichnet, dass** das molare Verhältnis der Sulfonsäuregruppen im (i) sulfonierten Copolymer zum Liganden (XR²Y), insbesondere zu einem Acetylacetonat-Liganden; im (iii) Metallkomplex der Formel I im Bereich von 1 : 5 bis 5 : 1 liegt, bevorzugt 1 : 3 bis 3 : 1, insbesondere 1 : 2 bis 2 : 1, vorzugsweise um 1 : 1 mit einer Schwankungsbreite von plus/minus 0,5, insbesondere 0,2.

15. Klebemasse nach einem der Ansprüche 1 bis 14 **dadurch gekennzeichnet, dass** sie einen SAFT-Wert größer gleich 150 °C, insbesondere größer gleich 180 °C, besonders bevorzugt größer gleich 200 °C bis vorzugsweise mindestens 250 °C aufweist.

16. Klebemasse nach einem der Ansprüche 1 bis 15, **dadurch gekennzeichnet, dass** sie als Klebharze mindestens ein hydriertes Harz, insbesondere ein hydriertes Kohlenwasserstoffharz enthält.

17. Klebemasse nach einem der Ansprüche 1 bis 16, **dadurch gekennzeichnet, dass** sie ein Reaktivharz enthält, insbesondere ein Epoxidharz, ein Acrylat- und/oder ein Methacrylat, wobei die Klebemasse optional zusammen mit mindesten einem Reaktivharz mindestens einen Photoinitiator enthält, insbesondere absorbiert der Photoinitiator UV-Licht unterhalb 350 nm.

18. Klebemasse nach einem der Ansprüche 1 bis 17, **dadurch gekennzeichnet, dass** die chelatvernetzte Klebemasse einen WVTR kleiner gleich 100 g/m²·d, vorzugsweise kleiner gleich 95 g/m²·d, bevorzugt kleiner gleich 80 g/m²·d, besonders bevorzugt kleiner gleich 20 g/m²·d, und/oder die chelatvernetzte Klebemasse eine OTR kleiner gleich 7000 g/m²·d·bar aufweist, insbesondere kleiner gleich 3000 g/m²·d·bar.

19. Klebemasse nach einem der Ansprüche 1 bis 18, **dadurch gekennzeichnet, dass** es eine Haftklebmasse oder eine Schmelzklebmasse ist.

20. Verfahren zur Herstellung einer Klebemasse, insbesondere zur Kapselung gegen Permeanten, indem
(i) Blockcopolymere sowie Mischungen dieser, mit einem Aufbau A-B-A, (A-B)ₙ, (A-B)ₙX oder (A-B-A)ₙX, wobei X der Rest eines Kopplungsreagenzes ist, n eine ganze Zahl zwischen 2 und 10, A ein Polymerblock aus einem Vinylaromaten und B ein Polymerblock aus einem Alken oder Dien, wobei dieser Polymerblock insbesondere hydriert ist, mit der Bedingung, dass zumindest ein Teil der A-Blöcke sulfoniert ist, optional als Zumischkomponente Zweiblockcopolymere der Form A-B, und
(ii) mindestens ein Klebharz gemischt werden.

21. Verfahren zur Herstellung einer Klebemasse, nach Anspruch 20, **dadurch gekennzeichnet, dass** zusätzlich
(iii) mindestens ein Metallkomplex mit einem substituierbaren Komplexbildner und optional als (ii) Klebharz ein im Wesentlichen vollständig hydriertes Kohlenwasserstoffharz, (iv) ein Weichmacher und optional (v) ein Füllstoff, Additiv, Beschleuniger, Photoinitiator und/oder optional (vi) ein Reaktivharz, insbesondere zusammen mit mindestens einem Photoinitiator, zugesetzt werden.

22. Klebemasse erhältlich nach einem Verfahren nach einem der Ansprüche 20 oder 21.

23. Verwendung einer Klebemasse, insbesondere nach einem der Ansprüche 1 bis 19 oder 22 sowie das Verfahrenserzeugnis nach einem der Ansprüche 20 oder 21, **dadurch gekennzeichnet, dass** die Klebemasse vor einer Applikation teilvernetzt wird oder nach einer Applikation teil- oder endvernetzt wird, insbesondere durch Erwärmen der Klebemasse und/oder des Elementes vor, während oder nach der Applikation der Klebemasse auf dem Element.

24. Verwendung nach Anspruch 23, **dadurch gekennzeichnet, dass** die Klebemasse vor einer Applikation thermisch teilvernetzt und nach der Applikation thermisch und/oder mit UV-Licht endvernetzt wird.

25. Verwendung einer Klebemasse, insbesondere nach einem der Ansprüche 1 bis 19 oder 22 sowie des Verfahrenserzeugnisses nach einem der Ansprüche 20 oder 21, oder eines mit der Klebemasse gebildeten ein- oder doppelseitig klebenden Klebebandes als Klebeverbund zur Ausbildung von Barriereschichten, vorzugsweise als Klebeband zur Ausbildung von temperaturstabilen Barriereschichten, insbesondere mit einem SAFT-Wert größer gleich 180 °C, als Barrieremasse zur Vermeidung der Diffusion von Permeanten, zur Kapselung einer elektronischen Anordnung, zur Kapselung einer optoelektronischen Anordnung.

26. Flächiges Haftmittel umfassend die Klebemasse nach einem der Ansprüche 1 bis 19, 22 sowie eines Verfahrensproduktes nach einem der Ansprüche 20 oder 21, wobei das flächige Haftmittel ausgewählt ist aus einem Flächenelement der Klebemasse und einem Klebeband, wobei das Klebeband einen Träger und auf mindestens einer Seite des Trägers die aufgebrachte Klebemasse aufweist, und die Klebemasse des flächigen Haftmittels im Wesentlichen getrocknet ist.

## Claims

1. Adhesive, especially as a permeant barrier, **characterized in that** the adhesive comprises
(i) block copolymers and also mixtures thereof, having an A-B-A, (A-B)ₙ, (A-B)ₙX, or (A-B-A)ₙX construction, where X is the radical of a coupling reagent, n is an integer between 2 and 10, A is a polymer block of a vinylaromatic, and B is a polymer block of an alkene or diene, and where some of the A blocks are sulfonated, and diblock copolymers of the form A-B optionally as admixture component, and
(ii) at least one tackifier resin.

2. Adhesive according to Claim 1, **characterized in that** B is a hydrogenated polymer block of an alkene or diene.

3. Adhesive according to Claim 1 or 2, **characterized in that** some of the block copolymers are in the form of sulfonated copolymers and have sulfonated A blocks, the aromatic moieties of which are sulfonated to an extent of between greater than or equal to 0.5 mol%, more particularly to an extent of greater than or equal to 0.5 to 20 mol% per mole of the monomer unit, based on the total monomer units of the A blocks in the sulfonated copolymer, more particularly greater than or equal to 0.5 to 15 mol%.

4. Adhesive according to any of Claims 1 to 3, **characterized in that** it further comprises (iii) at least one metal complex with a substitutable complexing agent.

5. Adhesive according to any of Claims 1 to 4, **characterized in that** the admixture component is a diblock copolymer of the form A-B, a copolymer with polymer blocks A' of vinylaromatics and polymer blocks B' of an alkene or diene.

6. Adhesive according to any of Claims 1 to 5, **characterized in that** (i) the A blocks each independently have a T_{g} of more than 40°C and the B blocks each independently have a T_{g} of less than 0°C.

7. Adhesive according to any of Claims 1 to 6, **characterized in that** the B blocks independently are selected homopolymers or copolymers of monomers are from ethylene, propylene, 1,3-dienes, more particularly from butadiene and/or isoprene.

8. Adhesive according to any of Claims 1 to 7, **characterized in that** the B blocks are at least partially hydrogenated, more particularly substantially fully hydrogenated.

9. Adhesive according to any of Claims 1 to 8, **characterized in that** the A blocks independently are selected homopolymers or copolymers of monomers from with at least one vinylaromatic such as styrene, styrene derivatives and/or α-methylstyrene.

10. Adhesive according to any of Claims 4 to 9, **characterized in that** the metal complex with a substitutable complexing agent corresponds to a metal chelate of the formula I,
(R¹O)ₙM (XR²Y)ₘ (I)
where M is a metal selected from metals of main groups 2, 3, 4, and 5 of the Periodic Table of the Elements and from the transition metals, M being selected more particularly from aluminum, tin, titanium, zirconium, hafnium, vanadium, niobium, chromium, manganese, iron, cobalt, and cerium, and M very preferably being aluminum or titanium, and
R¹ is an alkyl or aryl group, more particularly having 1 to 12 C atoms, such as methyl, ethyl, butyl, isopropyl, or benzyl;
n is 0 or a larger integer, more particularly 0, 1, 2, 3, or 4,
X and Y in the chelate ligand (XR²Y) independently are oxygen or nitrogen, which are optionally bonded to R² by a double bond,
R² is an alkylene group which joins X and Y and which is linear or branched, and optionally has heteroatom(s) in the alkylene group, more particularly oxygen, nitrogen, or sulfur;
m is an integer, but is at least 1, more particularly a number selected from 1, 2, or 3.

11. Adhesive according to Claim 10, **characterized in that** the chelate ligand in the metal chelate is formed from the reaction of at least one of the compounds selected from triethanolamine, 2,4-pentanedione, 2-ethyl-1,3-hexanediol, or lactic acid.

12. Adhesive according to any of Claims 1 to 11, **characterized in that** the overall composition of the adhesive contains
(ii) at 10 to 70 wt%, at least one tackifier resin, more particularly a hydrocarbon resin, which is preferably substantially fully hydrogenated, and/or an epoxy resin, and
(iii) at least one metal complex with a substitutable complexing agent, and optionally
(iv) up to 20 wt%, a plasticizer, and
(v) 0.0 to 20 wt%, fillers, additives, photoinitiators, accelerators and/or curing agents,
(vi) up to 60 wt%, a reactive resin, more particularly 5 to 40 wt%, and
(i) the block copolymers and/or mixtures comprising them, to 100 wt%, preferably at greater than or equal to 25 to 80 wt%.

13. Adhesive according to any of Claims 8 to 12, **characterized in that** the fraction in wt% of the vinylaromatics of the A blocks in the (i) copolymer in relation to the overall composition of the adhesive is at least 20 to 85 wt%, preferably 20 to 80 wt%, more preferably between greater than or equal to 30 to less than or equal to 65 wt%.

14. Adhesive according to any of Claims 1 to 13, **characterized in that** the molar ratio of the sulfonic acid groups in the (i) sulfonated copolymer to the ligand (XR²Y), more particularly to an acetylacetonate ligand; in the (iii) metal complex of the formula I is in the range from 1:5 to 5:1, preferably 1:3 to 3:1, more particularly 1:2 to 2:1, preferably around 1:1 with a fluctuation range of plus/minus 0.5, more particularly 0.2.

15. Adhesive according to any of Claims 1 to 14, **characterized in that** it has a SAFT of greater than or equal to 150°C, more particularly greater than or equal to 180°C, very preferably greater than or equal to 200°C to preferably at least 250°C.

16. Adhesive according to any of Claims 1 to 15, **characterized in that** it comprises as tackifier resins at least one hydrogenated resin, more particularly a hydrogenated hydrocarbon resin.

17. Adhesive according to any of Claims 1 to 16, **characterized in that** it comprises a reactive resin, more particularly an epoxy resin, an acrylate and/or a methacrylate, the adhesive, optionally together with at least one reactive resin, comprising at least one photoinitiator, the photoinitiator more particularly absorbing UV light below 350 nm.

18. Adhesive according to any of Claims 1 to 17, **characterized in that** the chelate-crosslinked adhesive has a WVTR of less than or equal to 100 g/m²·d, preferably less than or equal to 95 g/m²·d, more preferably less than or equal to 80 g/m²·d, very preferably less than or equal to 20 g/m²·d, and/or the chelate-crosslinked adhesive has an OTR of less than or equal to 7000 g/m²·d·bar, more particularly less than or equal to 3000 g/m²·d·ar.

19. Adhesive according to any of Claims 1 to 18, **characterized in that** it is a pressure-sensitive adhesive or a hotmelt adhesive.

20. Process for producing an adhesive, more particularly for encapsulation against permeants, by mixing
(i) block copolymers and also mixtures thereof, having an A-B-A, (A-B)ₙ, (A-B)ₙX, or (A-B-A)ₙX construction, where X is the radical of a coupling reagent, n is an integer between 2 and 10, A is a polymer block of a vinylaromatic, and B is a polymer block of an alkene or diene, this polymer block more particularly being hydrogenated, with the proviso that at least some of the A blocks are sulfonated, and diblock copolymers of the form A-B optionally as admixture component, and
(ii) at least one tackifier resin.

21. Process for producing an adhesive according to Claim 20, **characterized in that** additionally
(iii) at least one metal complex with a substitutable complexing agent and optionally as (ii) tackifier resin a substantially fully hydrogenated hydrocarbon resin, (iv) a plasticizer, and optionally (v) a filler, additive, accelerator, photoinitiator and/or optionally (vi) a reactive resin, more particularly together with at least one photoinitiator, are added.

22. Adhesive obtainable by a process according to either of Claims 20 and 21.

23. Use of an adhesive, more particularly according to any of Claims 1 to 19 and 22, and the process product according to either of Claims 20 and 21, **characterized in that** the adhesive is partially crosslinked prior to application or is partially crosslinked or crosslinked to completion after application, more particularly by heating of the adhesive and/or of the element before, during, or after the application of the adhesive to the element.

24. Use according to Claim 23, **characterized in that** the adhesive is thermally partially crosslinked prior to an application, and following the application, crosslinking to completion is accomplished thermally and/or with UV light.

25. Use of an adhesive, more particularly according to any of Claims 1 to 19 and 22, and of the process product according to either of Claims 20 and 21, or of a single-sided or double-sided adhesive tape formed with the adhesive, as an adhesive assembly for formation of barrier layers, preferably as an adhesive tape for formation of temperature-stable barrier layers, more particularly having a SAFT of greater than or equal to 180°C, as a barrier composition for preventing the diffusion of permeants, for encapsulating an electronic arrangement, for encapsulating an optoelectronic arrangement.

26. Sheetlike bonding means comprising the adhesive according to any of Claims 1 to 19 and 22 and a process product according to either of Claims 20 and 21, the sheetlike bonding means being selected from a sheetlike element of the adhesive and an adhesive tape, the adhesive tape having a carrier and, on at least one side of the carrier, the applied adhesive, and the adhesive of the sheetlike bonding means having been substantially dried.

## Revendications

1. Masse adhésive, en particulier en tant que barrière de produits de perméation, **caractérisée en ce que** la masse adhésive comprend
(i) des copolymères à blocs ainsi que des mélanges de ceux-ci, comportant une structure A-B-A, (A-B)ₙ, (A-B)ₙX ou (A-B-A)ₙX, X étant le radical d'un réactif de couplage, n étant un nombre entier compris entre 2 et 10, A étant un bloc de polymère d'un composé vinylaromatique et B étant un bloc de polymère d'un alcène ou d'un diène, et une partie des blocs A étant sulfonés, éventuellement en tant que composant de mélange de copolymères à deux blocs de forme A-B, et
(ii) au moins une résine adhésive.

2. Masse adhésive selon la revendication 1, **caractérisée en ce que** B est un bloc de polymère hydrogéné d'un alcène ou d'un diène.

3. Masse adhésive selon la revendication 1 ou 2, **caractérisée en ce qu'**une partie des copolymères à blocs sont présents en tant que copolymères sulfonés et présentent des blocs A sulfonés, dont les composés aromatiques sont sulfonés entre supérieur ou égal à 0,5 % en moles, en particulier dans une mesure supérieure ou égale à 0,5 et jusqu'à 20 % en moles par mole du motif monomérique par rapport aux motifs monomériques totaux des blocs A dans le copolymère sulfoné, en particulier dans une mesure supérieure ou égale à 0,5 et jusqu'à 15 % en moles.

4. Masse adhésive selon l'une quelconque des revendications 1 à 3, **caractérisée en ce qu'**elle comprend en outre (iii) au moins un complexe métallique comportant un agent complexant substituable.

5. Masse adhésive selon l'une quelconque des revendications 1 à 4, **caractérisée en ce que** le composant de mélange est un copolymère à deux blocs de forme A-B, un copolymère comportant des blocs de polymère A' de composés vinylaromatiques et des blocs de polymère B' d'un alcène ou d'un diène.

6. Masse adhésive selon l'une quelconque des revendications 1 à 5, **caractérisée en ce que** (i) les blocs A présentent à chaque fois indépendamment une Tᵥ supérieure à 40 °C et les blocs B présentent à chaque fois indépendamment une Tᵥ inférieure à 0 °C.

7. Masse adhésive selon l'une quelconque des revendications 1 à 6, **caractérisée en ce que** les blocs B indépendamment sont choisis des homopolymères ou des copolymères composés de monomères sont parmi l'éthylène, le propylène, les 1,3-diènes, en particulier le butadiène et/ou l'isoprène.

8. Masse adhésive selon l'une quelconque des revendications 1 à 7, **caractérisée en ce que** les blocs B sont au moins partiellement hydrogénés, en particulier essentiellement totalement hydrogénés.

9. Masse adhésive selon l'une quelconque des revendications 1 à 8, **caractérisée en ce que** les blocs A indépendamment sont choisis des homopolymères ou des copolymères composés de monomères parmi avec au moins un composé vinylaromatique comme le styrène, des dérivés de styrène et/ou l'a-méthylstyrène.

10. Masse adhésive selon l'une quelconque des revendications 4 à 9, **caractérisée en ce que** le complexe métallique comportant un agent complexant substituable correspond à un chélate métallique de formule I,
(R¹O)ₙM (XR²Y)ₘ (I)
M étant un métal choisi parmi les métaux des groupes principaux 2, 3, 4, et 5 du système périodique des éléments et les métaux de transition, en particulier M étant choisi parmi l'aluminium, l'étain, le titane ; le zirconium, le hafnium, le vanadium, le niobium, le chrome, le manganèse, le fer, le cobalt et le cérium, M étant particulièrement préférablement l'aluminium ou le titane, et
R¹ étant un groupe alkyle ou aryle, en particulier comportant 1 à 12 atomes de C, comme méthyle, éthyle, butyle, isopropyle ou benzyle ;
n étant égal à 0 ou étant un nombre entier plus grand, en particulier 0, 1, 2, 3 ou 4,
X et Y dans le ligand chélate (XR²Y) étant indépendamment oxygène ou azote, qui sont éventuellement liés par une double liaison à R²,
R² étant un groupe alkylène reliant X et Y, qui est linéaire ou ramifié, et éventuellement avec un hétéroatome ou des hétéroatomes dans le groupe alkylène, en particulier oxygène, azote ou soufre ;
m étant un nombre entier, néanmoins au moins 1, en particulier un nombre choisi parmi 1, 2 ou 3.

11. Masse adhésive selon la revendication 10, **caractérisée en ce que** le ligand chélate dans le chélate métallique est formé par la réaction d'au moins un des composés choisis parmi la triéthanolamine, la 2,4-pentanedione, le 2-méthyl-1,3-hexanediol et l'acide lactique.

12. Masse adhésive selon l'une quelconque des revendications 1 à 11, **caractérisée en ce que**
(ii) de 10 à 70 % en poids d'au moins une résine adhésive, en particulier d'une résine d'hydrocarbure, qui est de préférence essentiellement totalement hydrogénée, et/ou d'une résine époxy, et
(iii) au moins un complexe métallique comportant un agent complexant substituable et
éventuellement
(iv) jusqu'à 20 % en poids d'un plastifiant et
(v) 0,0 à 20 % en poids de charges, d'additifs, de photoinitiateurs, d'accélérateurs et/ou de durcisseurs,
(vi) jusqu'à 60 % en poids d'une résine réactive, en particulier 5 à 40 % en poids, et
(i) les copolymères à blocs ou des mélanges comprenant ceux-ci sont contenus jusqu'à 100 % en poids dans la composition totale de la masse adhésive, de préférence dans une mesure supérieure ou égale à 25 et jusqu'à 80 % en poids.

13. Masse adhésive selon l'une quelconque des revendications 8 à 12, **caractérisée en ce que** la proportion en % en poids des composés vinylaromatiques des blocs A dans (i) le copolymère par rapport à la composition totale de la masse adhésive est d'au moins 20 à 85 % en poids, de préférence 20 à 80 % en poids, particulièrement préférablement supérieure ou égale à 30 et inférieure ou égale à 65 % en poids.

14. Masse adhésive selon l'une quelconque des revendications 1 à 13, **caractérisée en ce que** le rapport molaire des groupes acide sulfonique dans (i) le copolymère sulfoné sur le ligand (XR²Y), en particulier sur un ligand acétylacétonate, dans (iii) le complexe métallique de formule I se situe dans la plage de 1:5 à 5:1, préférablement 1:3 à 3:1, en particulier 1:2 à 2:1, de préférence 1:1 avec une marge de fluctuation de plus/moins 0,5, en particulier 0,2.

15. Masse adhésive selon l'une quelconque des revendications 1 à 14, **caractérisée en ce qu'**elle présente une valeur SAFT supérieure ou égale à 150 °C, en particulier supérieure ou égale à 180 °C, particulièrement préférablement supérieure ou égale à 200 °C jusqu'à de préférence au moins 250 °C.

16. Masse adhésive selon l'une quelconque des revendications 1 à 15, **caractérisée en ce qu'**elle contient en tant que résine adhésive au moins une résine hydrogénée, en particulier une résine d'hydrocarbure hydrogénée.

17. Masse adhésive selon l'une quelconque des revendications 1 à 16, **caractérisée en ce qu'**elle contient une résine réactive, en particulier une résine époxy, un acrylate et/ou un méthacrylate, la masse adhésive contenant éventuellement, ensemble avec au moins une résine réactive, au moins un photoinitiateur, en particulier le photoinitiateur absorbant la lumière UV en dessous de 350 nm.

18. Masse adhésive selon l'une quelconque des revendications 1 à 17, **caractérisée en ce que** la masse adhésive réticulée par un chélate présente un WVTR inférieur ou égal à 100 g/m² · d, de préférence inférieur ou égal à 95 g/m² · d, préférablement inférieur ou égal à 80 g/m² · d, particulièrement préférablement inférieur ou égal à 20 g/m² · d, et/ou la masse adhésive réticulée par un chélate présente un OTR inférieur ou égal à 7 000 g/m² · d · bar, en particulier inférieur ou égal à 3 000 g/m² · d · bar.

19. Masse adhésive selon l'une quelconque des revendications 1 à 18, **caractérisée en ce que** c'est une masse autoadhésive ou une masse adhésive thermofusible.

20. Procédé pour la préparation d'une masse adhésive, en particulier pour l'encapsulation pour la protection contre des produits de perméation, dans lequel
(i) des copolymères à blocs ainsi que des mélanges de ceux-ci, comportant une structure A-B-A, (A-B)ₙ, (A-B)ₙX ou (A-B-A)ₙX, X étant le radical d'un réactif de couplage, n étant un nombre entier compris entre 2 et 10, A étant un bloc de polymère d'un composé vinylaromatique et B étant un bloc de polymère d'un alcène ou d'un diène, ce bloc de polymère étant notamment hydrogéné, à condition qu'au moins une partie des blocs A soient sulfonés, éventuellement en tant que composant de mélange de copolymères à deux blocs de forme A-B, et
(ii) au moins une résine adhésive sont mélangés.

21. Procédé pour la préparation d'une masse adhésive, selon la revendication 20, **caractérisé en ce que** de plus
(iii) au moins un complexe métallique comportant un agent complexant substituable et éventuellement, en tant que (ii) résine adhésive, une résine d'hydrocarbure essentiellement totalement hydrogénée, (iv) un plastifiant et éventuellement (v) une charge, un additif, un accélérateur, un photoinitiateur et/ou éventuellement (vi) une résine réactive, en particulier ensemble avec au moins un photoinitiateur, sont ajoutés.

22. Masse adhésive pouvant être obtenue par un procédé selon l'une quelconque des revendications 20 et 21.

23. Utilisation d'une masse adhésive, en particulier selon l'une quelconque des revendications 1 à 19 ou 22 ainsi que produit de procédé selon l'une quelconque des revendications 20 et 21, caractérisé(e) en ce que la masse adhésive est partiellement réticulée avant une application ou est partiellement ou totalement réticulée après une application, en particulier par chauffage de la masse adhésive et/ou de l'élément avant, pendant ou après l'application de la masse adhésive sur l'élément.

24. Utilisation selon la revendication 23, **caractérisée en ce que** la masse adhésive est partiellement réticulée thermiquement avant une application et est totalement réticulée thermiquement et/ou avec de la lumière UV après l'application.

25. Utilisation d'une masse adhésive, en particulier selon l'une quelconque des revendications 1 à 19 ou 22 ainsi que du produit de procédé selon l'une quelconque des revendications 20 et 21, ou d'un ruban adhésif adhérant sur une face ou une double face, formé avec la masse adhésive, en tant que composite adhésif pour la formation de couches barrières, de préférence en tant que ruban adhésif pour la formation de couches barrières stables en température, en particulier comportant une valeur SAFT supérieure ou égale à 180 °C, en tant que masse barrière pour empêcher la diffusion de produits de perméation, pour l'encapsulation d'un dispositif électronique, pour l'encapsulation d'un dispositif optoélectronique.

26. Agent adhésif plat comprenant la masse adhésive selon l'une quelconque des revendications 1 à 19, 22 ainsi qu'un produit de procédé selon l'une quelconque des revendications 20 et 21, l'agent adhésif plat étant choisi parmi un élément plat de la masse adhésive et un ruban adhésif, le ruban adhésif présentant un support et la masse adhésive appliquée sur au moins l'une des faces du support, et la masse adhésive de l'agent adhésif plat étant essentiellement séchée.
